# EUROPEAN PATENT APPLICATION

(11) **EP 4 459 670 A1**
(43) Date of publication of application: **06.11.2024**
(21) Application number: 23219749.1
(22) Date of filing: 22.12.2023
(51) Int. Cl.: H01L 21/768, H01L 23/528, H01L 27/118

(54) **SEMICONDUCTOR DEVICE AND MANUFACTURING METHOD THEREOF**

(30) Priority: 02.05.2023 KR 20230057037
(71) Applicant: Samsung Electronics Co., Ltd., Suwon-si, Gyeonggi-do 16677 (KR)
(72) Inventor: SHIN, Jongmin, Suwon-si (KR); SHIN, Heonjong, Suwon-si (KR); PARK, June Young, Suwon-si (KR); JANG, Jaeran, Suwon-si (KR)
(74) Representative: Marks & Clerk LLP

(57) **Abstract**

A semiconductor device may include a support member, an active region, source and drain regions, and a gate electrode. The support member may include a substrate insulation layer including separating insulators and a power wire disposed at a space between the separating insulators. The active region may be disposed on the power wire. The source and drain regions may be positioned adjacent to the active region. The gate electrode may be disposed on the active region.

## Description

### BACKGROUND

### (a) Field of the Disclosure

The present disclosure relates to semiconductor devices and/or manufacturing methods thereof, and particularly relates to structure-improved semiconductor devices and/or manufacturing methods thereof.

### (b) Description of the Related Art

Semiconductor devices are used in various electronic devices, such as storage devices that store data and processors that calculate and process data. With the development of the electronic industry, various methods for improving various properties such as integration, reliability, speeds, and functions of the semiconductor devices are being researched. For example, semiconductor devices having a three-dimensional structure have been proposed to overcome limitations caused by a size reduction of semiconductor devices.

### SUMMARY

The present disclosure attempts to provide semiconductor devices with improved performance and/or high productivity, and manufacturing methods thereof.

An example embodiment of the present disclosure provides a semiconductor device including a support member, an active region, source and drain regions, and a gate electrode. The support member may include a substrate insulation layer including a plurality of separating insulators, and a power wire being at a space between the separating insulators. The active region may be on the power wire. The source and drain regions may be adjacent to the active region. The gate electrode may be on the active region.

An example embodiment of the present disclosure provides a semiconductor device including a support member, a rear wire portion, a rear insulation layer, a plurality of channel layers, source and drain regions, and a gate electrode. The support member may include a substrate insulation layer including a plurality of separating insulators. The rear wire portion may include a power wire and a rear wire layer, the power wire being at a space between the plurality of separating insulators and the rear wire layer being on a rear side of the power wire. The rear insulation layer may be on a front side of the power wire. The plurality of channel layers may be on a front side of the rear insulation layer and spaced apart from each other. The source and drain regions may be adjacent to the plurality of channel layers. The gate electrode may be on the channel layers.

An example embodiment of the present disclosure provides a method of manufacturing a semiconductor device including providing a support structure including a substrate, forming a substrate insulation layer, forming source and drain regions and a gate electrode on the support structure, forming a space portion, and forming a power wire. The forming of the substrate insulation layer may form the substrate insulation layer including a separating insulator and an upper insulator by forming a plurality of first separators and a second separator and filling the first separators and the second separator with an insulating material, a rear side of the second separator being higher than the first separators in the support structure. The forming of the space portion may include removing at least a part of the substrate disposed between the first separators to form the space portion. The forming of the power wire may include filling a conductive material in the space portion to forming the power wire.

According to some example embodiments, a support member may include a substrate insulation layer and a power wire to simplify a structure of the semiconductor device and reduce a size of the semiconductor device, and to reduce or minimize a power transmitting path and prevent or reduce voltage drop. The power wire may be formed by the self-alignment process using a separating insulator, thereby simplifying a process for manufacturing a semiconductor device. According to this, performance and productivity of the semiconductor device may be increased.

At least some of the above and other features of the invention are set out in the claims.

### BRIEF DESCRIPTION OF THE DRAWINGS

FIG. 1 schematically shows a top plan view of a semiconductor device according to an example embodiment.
FIG. 2 shows a cross-sectional view with respect to lines A-A' and C-C' of FIG. 1.
FIG. 3A to FIG. 3J show a processing diagram of a method of manufacturing the semiconductor device shown in FIG. 1.
FIG. 4A to FIG. 4E show a processing diagram of a process for forming a first separator, a second separator, and a substrate insulation layer shown in FIG. 3B.
FIG. 5 shows a cross-sectional view of a semiconductor device according to another example embodiment.
FIG. 6A to FIG. 6H show a processing diagram of a method for manufacturing the semiconductor device shown in FIG. 5.
FIG. 7 shows a cross-sectional view of a variation of a semiconductor device shown in FIG. 5.
FIG. 8 shows a cross-sectional view of a semiconductor device according to another example embodiment.
FIG. 9 shows a cross-sectional view of a semiconductor device according to another example embodiment.

### DETAILED DESCRIPTION

Some example embodiments of the present disclosure will be described more fully hereinafter with reference to the accompanying drawings for those skilled in the art to which the present disclosure pertains to easily practice the present disclosure. The present disclosure may be implemented in various different forms and is not limited to the example embodiments provided herein.

A portion unrelated to the description is omitted in order to clearly describe the present disclosure, and the same or similar components are denoted by the same reference numeral throughout the present specification.

Further, since sizes and thicknesses of portions, regions, members, units, layers, films, etc. shown in the accompanying drawings may be arbitrarily shown for better understanding and ease of description, the present disclosure is not limited to the illustrated sizes and thicknesses. Thicknesses of some portions, regions, members, units, layers, films, etc. may be enlarged in the drawings in order to clarity. In addition, in the drawings, thicknesses of portions, regions, members, units, layers, films, etc. may be exaggerated for convenience of explanation.

It will be understood that when a component such as a layer, film, region, or substrate is referred to as being "on" another component, it may be directly on other component or intervening components may also be present. In contrast, when a component is referred to as being "directly on" another component, there are no intervening components present. Further, when a component is referred to as being "on" or "above" a reference component, a component may be positioned on or below the reference component, and does not necessarily be "on" or "above" the reference component toward an opposite direction of gravity.

In addition, unless explicitly described to the contrary, the word "comprise" or "include", and variations such as "comprises", "comprising", "includes", "or including", will be understood to imply the inclusion of other component rather than the exclusion of any other components.

Further, throughout the specification, a phrase "on a plane" or "in a plane" may indicate a case where a portion is viewed from above or a top portion, and a phrase "on a cross-section" or "in a cross-section" may indicate when a cross-section taken along a vertical direction is viewed from a side.

As used herein, expressions such as "at least one of," when preceding a list of elements, modify the entire list of elements and do not modify the individual elements of the list. Thus, for example, both "at least one of A, B, or C" and "at least one of A, B, and C" mean either A, B, C or any combination thereof. Likewise, A and/or B means A, B, or A and B.

While the term "same," "equal" or "identical" is used in description of example embodiments, it should be understood that some imprecisions may exist. Thus, when one element is referred to as being the same as another element, it should be understood that an element or a value is the same as another element within a desired manufacturing or operational tolerance range (e.g., ±10%).

When the terms "about" or "substantially" are used in this specification in connection with a numerical value, it is intended that the associated numerical value includes a manufacturing or operational tolerance (e.g., ±10%) around the stated numerical value. Moreover, when the words "about" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

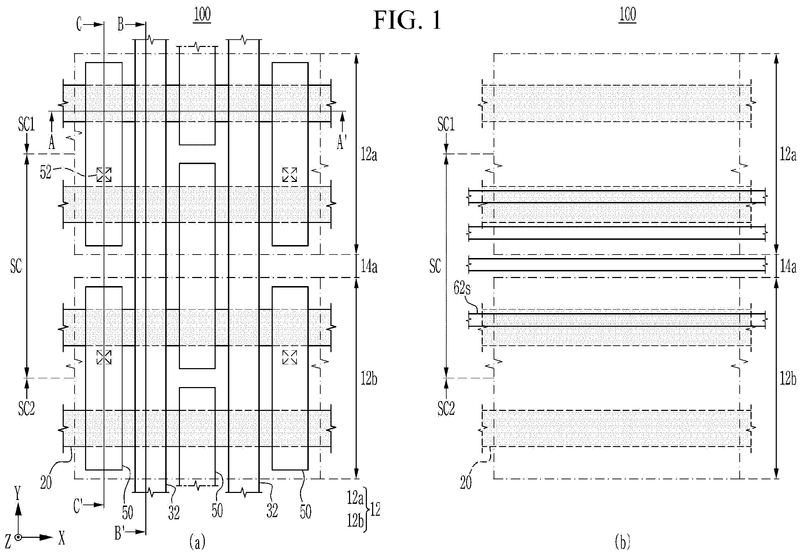

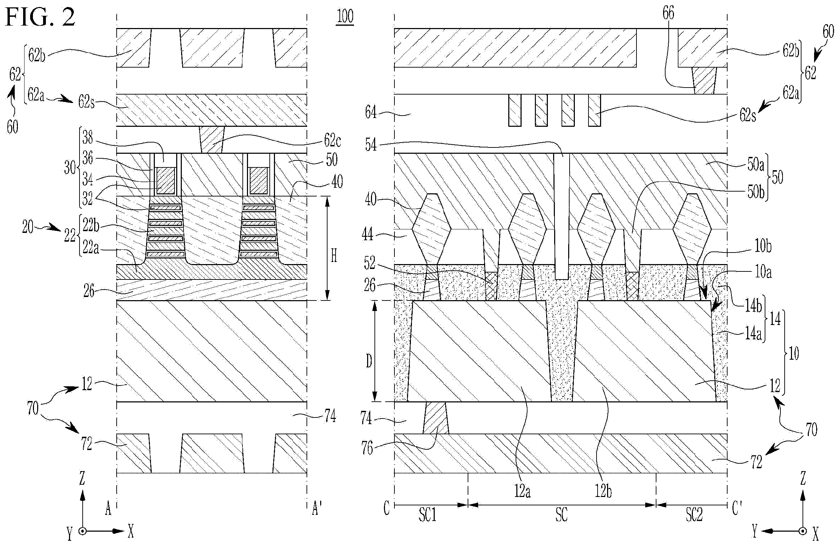

A semiconductor device according to an example embodiment will now be described with reference to FIG. 1 and FIG. 2. In the present specification, a front side or an upper portion may mean a side or a portion positioned in a direction in which a front wire portion 60 is disposed (e.g., a positive Z-axis direction in the drawing), and a rear side or a lower portion may mean a side or a portion positioned in a direction in which a rear wire portion 70 is disposed (e.g., a negative Z-axis direction in the drawing). As illustrated in FIG. 2, the front wire portion 60 is located vertically above (in the Z-axis direction) the rear wire portion 70. Thus, in one example, where a first component of the device is described as being on or at the front side of a second component, this may mean that the first component is vertically above the second component. Similarly, a first component described as being on or at the rear side of a second component may be vertically below the second component. Said another way, "front" may be interpreted as "upper" and "rear" may be interpreted as "lower".

FIG. 1 schematically shows a top plan view of a semiconductor device according to an example embodiment, and FIG. 2 shows a cross-sectional view with respect to lines A-A' and C-C' of FIG. 1. For clear understanding and brief illustration, (a) of FIG. 1 mainly shows a power wire 12, a separating insulator 14a, an active region 20, a gate electrode 32, and source and drain electrodes 50, and (b) of FIG. 1 mainly shows a power wire 12, a separating insulator 14a, an active region 20, and a signal wire 62s.

Referring to FIG. 1 and FIG. 2, the semiconductor device 100 includes a support member 10 including a power wire 12 disposed at a space between a plurality of separating insulators 14a, an active region 20 formed on the power wire 12, source and drain regions 40 positioned adjacent to the active region 20, and a gate electrode 32 disposed on the active region 20. This will now be described in detail.

In an example embodiment, the support member 10 may be formed of a substrate insulation layer 14 including a plurality of separating insulators 14a, and a power wire 12 buried or embedded in a space between the plurality of separating insulators 14a. As described, the power wire 12 may function as a wire layer constituting a part of a rear wire portion 70 and a support structure constituting a part of the support member 10.

The substrate insulation layer 14 may include a plurality of separating insulators or a plurality of separating insulating portions 14a disposed on a lateral side of the power wire 12 and an upper insulator or an upper insulating portion 14b. The upper insulator may cover an upper portion of the plurality of separating insulators 14a and the power wire 12 buried or embedded in a space between the separating insulators 14a. The separating insulators 14a may extend to a lower portion (e.g., extend downward) from the upper insulator 14b. FIG. 2 illustrates that the separating insulators 14a and the upper insulator 14b have an integrated structure with no borders therebetween. For example, at least some of the separating insulators 14a and the upper insulator 14b may be formed in different processes. In this case, the separating insulators 14a and the upper insulator 14b may be made of the same material. Also, the separating insulators 14a and the upper insulator 14b may be formed by an identical or very similar process, may have no borders, and thus may not be distinguished from each other. However, example embodiments are not limited thereto, and the substrate insulation layer 14 may include a plurality of portions including different materials.

In an example embodiment, a first separator or a first separating portion 10a and a second separator or a second separating portion 10b may be included in the support member 10, and the substrate insulation layer 14 may fill the first separator 10a and the second separator 10b. A portion of the first separator 10a filled with an insulating material may constitute the separating insulator 14a, and a portion of the second separator 10b filled with an insulating material may constitute the upper insulator 14b. Here, a rear side of the first separator 10a or the separating insulator 14a may be disposed lower than a rear side of the second separator 10b or the upper insulator 14b. The first separator 10a filled with the separating insulator 14a may be a deep trench isolation (DTI) and the second separator 10b filled with the upper insulator 14b may be a shallow trench isolation (STI).

Here, the first separator 10a or the separating insulator 14a may be disposed to extend from a rear side of the power wire 12 (e.g., a rear side of the support member 10) to a front side of the power wire 12. In an example embodiment, the first separator 10a or the separating insulator 14a may extend in a first direction (an X-axis direction in the drawing), and the first separators 10a or the separating insulators 14a may be spaced at regular intervals with a power wire 12 therebetween in a second direction (a Y-axis direction in the drawing). The separating insulator 14a may be disposed to separate and insulate the power wires 12 in the second direction (the Y-axis direction in the drawing).

A rear side of the power wire 12 may constitute a rear side of the support member 10 in a space between first separators 10a or separating insulators 14a, and a depth D of the first separator 10a or the separating insulator 14a may be substantially equivalent to a thickness of the power wire 12. Here, the phrase "substantially equivalent" includes a case of a difference within an error range (e.g., 5%) in addition to a case of the same. For example, the depth D of the first separator 10a or the separating insulator 14a may be less than a height (H) to a front side of the active region 20 from the front side of the power wire 12. In the present example embodiment, the power wire 12 is formed to have a big area in a portion excluding the separating insulator 14a so the power wire 12 could have a relatively small thickness. In consideration of this, the depth D of the first separator 10a or the separating insulator 14a corresponding to the thickness of the power wire 12 may be relatively small. This will be described in detail in a subsequent manufacturing process.

However, example embodiments are not limited thereto, and the depth D of the first separator 10a or the separating insulator 14a may be equal to or greater than the height (H) to the front side of the active region 20 from the front side of the power wire 12.

The second separator 10b or the upper insulator 14b may be disposed to extend from the front side of the power wire 12 to the front side of the substrate insulation layer 14 (e.g., the front side of the separating insulator 14a). In an example embodiment, the second separator 10b or the upper insulator 14b may extend in the first direction (the X-axis direction in the drawing), and the second separators 10b or the upper insulators 14b may be spaced at regular intervals with the active region 20 therebetween in the second direction (a Y-axis direction in the drawing). The second separator 10b or the upper insulator 14b may be disposed to separate and insulate the active regions 20 in the second direction (the Y-axis direction in the drawing).

In an example embodiment, a front side of the second separator 10b or the upper insulator 14b may be disposed on a same plane as the rear side of the source and drain regions 40 or on a plane adjacent to the rear side of the source and drain regions 40. When a border between the upper insulator 14b of the substrate insulation layer 14 and another insulator or an insulation layer formed thereon is not clear, the upper insulator 14b may be defined to a portion up to a rear side of the source and drain regions 40 from the front side of the power wire 12. This is because the source and drain regions 40 are formed after forming the substrate insulation layer 14 in the manufacturing process. However, example embodiments are not limited thereto. The upper insulator 14b may not be separately provided, or a portion of the upper insulator 14b may be removed in a thickness direction when the source and drain regions 40 are formed.

The power wire 12 may extend in the first direction between two neighboring separating insulators 14a among the separating insulators 14a. The power wires 12 may be spaced at regular intervals in the second direction.

In an example embodiment, the separating insulator 14a may be disposed corresponding to a center region of a standard cell SC in the second direction. The power wire 12 may include a first power wire 12a shared by the standard cell SC and a first adjacent cell SC1, and a second power wire 12b shared by the standard cell SC and a second adjacent cell SC2. The standard cell SC and the first and second adjacent cells SC1 and SC2 may be standard cells and the terms of the standard cell SC and the first and second adjacent cells SC1 and SC2 are used to distinguish from each other. Here, the first adjacent cell SC1 may represent a cell adjacent to one side of the standard cell SC in the second direction, and the second adjacent cell SC2 may represent a cell adjacent to another side of the standard cell SC in the second direction. By this, the power wire 12 for applying power voltages to the standard cell SC and the first and second adjacent cells SC1 and SC2 may be more easily formed by a process for forming the separating insulator 14a in the center region and filling the space between the separating insulators 14a with the power wire 12 for the respective standard cells SC.

However, example embodiments are not limited thereto. In some example embodiments, the separating insulator 14a may be formed at a border region of the standard cell SC, and the first and second power wires 12a and 12b of the standard cell SC may be separately formed. Other numerous variations are allowable.

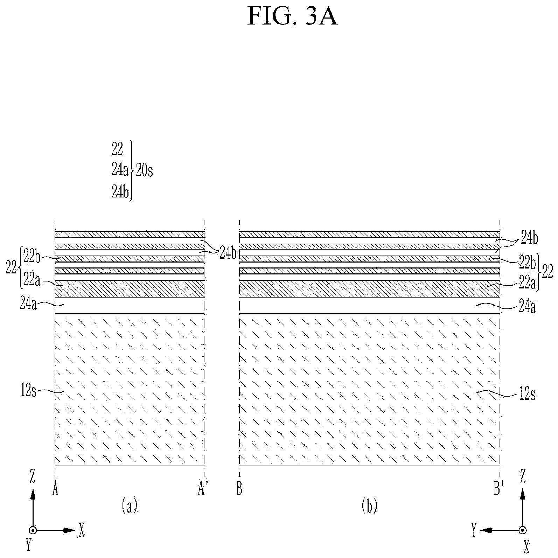

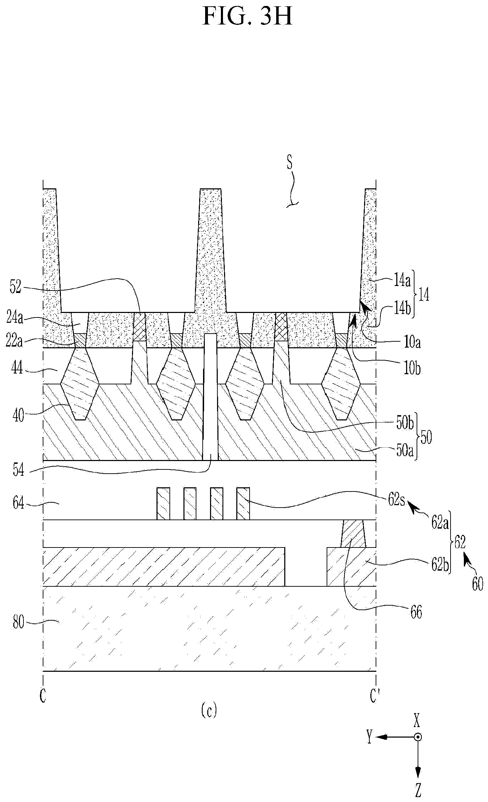

In a manufacturing process, a substrate including a semiconductor material 12s (refer to FIG. 3A) and a stacking structure 20s (refer to FIG. 3A) formed thereon may be removed by an etching process to form the first separator 10a and the second separator 10b, and an insulation layer may be formed on the substrate 12s to fill the first separator 10a and the second separator 10b, thereby forming the substrate insulation layer 14. After the substrate insulation layer 14 is formed, a space (e.g., a space portion S of FIG. 3H) may be formed between the separating insulators 14a by removing the substrate 12s and the power wire 12 may be formed by filling a conductive material into the space portion S. The process for manufacturing the substrate insulation layer 14 and the power wire 12 will be described in more detail later.

According to the above manufacturing process, the support member 10 may be formed of the substrate insulation layer 14 and the power wire 12 without the substrate 12s including the semiconductor material, that is, without the semiconductor substrate. For example, at a portion on which the separating insulator 14a is not disposed, the power wire 12 may be disposed at a lower portion of the support member 10 and the upper insulator 14b may be disposed at an upper portion of support member 10. On the portion where the separating insulator 14a is disposed, the substrate insulation layer 14 may be disposed continuously (e.g. may extend) from the rear side of the support member 10 to the front side of the support member 10. Accordingly, the power wire 12 and the upper insulator 14b may constitute the support member 10 at the portion where the separating insulator 14a is not disposed, and the substrate insulation layer 14 may constitute the support member 10 at the portion where the separating insulator 14a is disposed (see FIG. 2). Accordingly, a structure of the semiconductor device 100 may be simplified, and the power wire 12 may be formed using the separating insulator 14a to simplify a manufacturing process and increase reliability.

For example, the power wire 12 may entirely fill the space between the separating insulators 14a, and an entire portion of a lateral side of the power wire 12 may contact an entire portion of a lateral side of the separating insulator 14a. However, example embodiments are not limited thereto, and a separate layer may be provided between the power wire 12 and the separating insulator 14a.

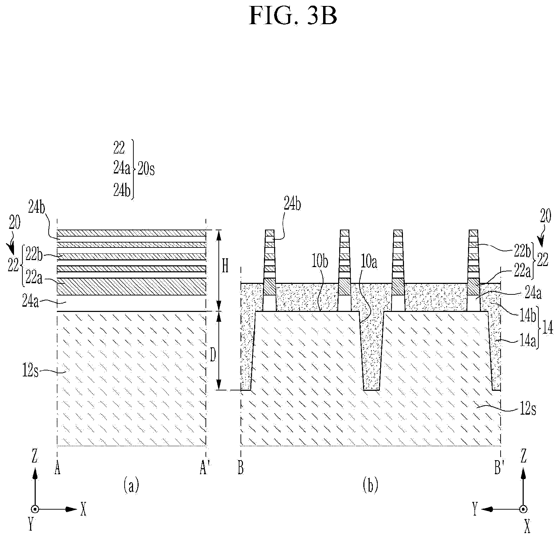

When viewed in a cross-section (a YZ plane in the drawing) that is perpendicular to the first direction, a lateral side that is a border side between the separating insulator 14a and the power wire 12 may include or be configured as a slope side or an inclined surface so that a width of the separating insulator 14a gradually narrows and a width of power wire 12 gradually widens when approaching the rear side of the support member 10 (e.g. moving downwards in a negative Z direction) from the front side of the support member 10 (see FIG. 3B, for example). This is because the first separator 10a for forming the separating insulator 14a is formed from the upper side of the support member 10. Accordingly, the power wire 12 may be formed by filling a conductive material from the rear side having a relatively large size in a process for forming the power wire 12. Accordingly, in the process of forming the power wire 12, the space portion S (refer to FIG. 3H) filled with a conductive material may have a positive slope to prevent generation of voids. This will be described in more detail later in the manufacturing process.

The substrate insulation layer 14 may include or be formed of any of various insulating materials. For example, the substrate insulation layer 14 may include silicon oxide, silicon nitride, silicon oxynitride, or combinations thereof, and example embodiments are not limited thereto. The power wire 12 may include or be formed of any of various conductive materials. For example, the power wire 12 may include at least one of tungsten, molybdenum, aluminum, copper, and cobalt or an alloy including the same. However, example embodiments are not limited to the disclosed materials of the substrate insulation layer 14 and the power wire 12.

In an example embodiment, the active region 20 may be disposed on the power wire 12, and the source and drain regions 40 may be positioned adjacent to the active region 20. A gate structure 30 including a gate electrode 32 may be disposed on the active region 20. Source and drain electrodes 50 may be electrically connected to the source and drain regions 40.

In an example embodiment, a rear insulation layer 26 forming a bottom dielectric isolation (BDI) structure may be disposed between the power wire 12 and the active region 20. Also, the rear insulation layer 26 may be disposed between the power wire 12 and the source and drain regions 40. The rear insulation layer 26 may be between the power wire 12 and the active region 20 and may insulate the power wire 12 and the active region 20. The rear insulation layer 26 may be between the power wire 12 and the source and drain regions 40 and may insulate the power wire 12 and the source and drain regions 40.

The rear insulation layer 26 may include any of various insulating materials. For example, the rear insulation layer 26 may include at least one of silicon oxide, silicon nitride, and silicon oxynitride, and example embodiments are not limited thereto. A thickness of the rear insulation layer 26 may be greater than a thickness of a channel layer 22 (for example, a second channel layer 22b) or a gap between the channel layers 22. According to this, an insulating property may be sufficiently obtained by the rear insulation layer 26. However, example embodiments are not limited thereto, and the thickness of the rear insulation layer 26 may be equal to or less than the thickness of the channel layer 22 (for example, the second channel layer 22b) or the gap between the channel layers 22.

The thickness of the rear insulation layer 26 may be less than a thickness of the upper insulator 14b. When the thickness of the upper insulator 14b is greater than the thickness of the rear insulation layer 26, the active region 20 may be stably separated and insulated, and a structure may be stably maintained when the substrate 12s is removed in a manufacturing process. However, example embodiments are not limited thereto.

In an example embodiment, the active region 20 may be disposed on the rear insulation layer 26. A portion of the active region 20 crossing the gate structure 30 may form or constitute a channel region of a transistor.

In an example embodiment, at least a portion (e.g., a first channel layer 22a) of the active region 20 may extend in the first direction (e.g., the X-axis direction in the drawing) between two neighboring upper insulators 14b among the upper insulators 14b. The active regions 20 may be spaced at regular intervals in the second direction (the Y-axis direction in the drawing). The active regions 20 may include channel layers 22 spaced from each other in the thickness direction (e.g., the Z-axis direction in the drawing) on the power wire 12. The channel layers 22 (e.g., the second channel layer 22b) each may have a nanosheet shape with the nanometer-level thickness, but example embodiments are not limited thereto, and the channel layers 22 may have any of various shapes.

In an example embodiment, the channel layers 22 may include a first channel layer 22a disposed adjacent to the power wire 12 with the rear insulation layer 26 therebetween, and one or a plurality of second channel layers 22b disposed on the first channel layer 22a. In an example embodiment, a thickness of the first channel layer 22a may be greater than a thickness of the second channel layer 22b. Thus, the first channel layer 22a may stably protect or maintain the active region 20 in a manufacturing process. For example, the first channel layer 22a may extend in the first direction (e.g., the X-axis direction in the drawing), and the second channel layers 22b may be spaced from each other in the first direction.

In another example embodiment, the first channel layer 22a that is a lowermost portion among the channel layers 22 may not be disposed at a lower portion of the source and drain regions 40. In this case, as the second channel layer 22b, the first channel layer 22a may be disposed between the source and drain regions 40 (e.g., between lateral sides of two neighboring source and drain regions 40) that are spaced apart from each other in the first direction. Thus, a plurality of first channel layers 22a may be spaced apart from each other with the source and drain regions 40 therebetween in the first direction (e.g. the X axis direction). In another example embodiment, the first channel layer 22a may not be formed, and a rear insulation layer 26 may be formed at a region of the first channel layer 22a of FIG. 2. According to this, the channel layers 22 or the active regions 20 may be entirely spaced from each other in the first direction. Hence, design freedom of the channel layer 22 or the active region 20 may be increased.

The channel layer 22 may include a semiconductor material, for example, at least one of a group IV semiconductor, a group III-V compound semiconductor, and a group II-VI compound semiconductor. For example, the channel layer 22 may include at least one of silicon (Si), germanium (Ge), and silicon-germanium (SiGe). The channel layer 22 may be a semiconductor layer. For example, the first channel layer 22a may be a semiconductor layer, and the second channel layer 22b may be a semiconductor layer. For example, each of the channel layer 22 may include a nanosheet layer with a nanometer-level (e.g., 1 nm to 10nm) thickness. For example, the first channel layer 22a may be a first nanosheet layer, and the second channel layer 22b may be a second nanosheet layer. A shape, a thickness, a material of the channel layer 22, and a number of the channel layers 22 forming one channel structure may be modified in many ways.

In an example embodiment, the channel layer 22 or at least a part of the first and/or second channel layers 22a and 22b constituting the same may include a portion that does not function as a channel of a transistor. For example, the first channel layer 22a may function as a channel between the source and drain regions 40, and one or at least one of the second channel layers 22b may not function as a channel because a movement of charges (holes or electrons) is suppressed.

In an example embodiment, a lateral side of the gate structure 30, which is disposed on the rear insulation layer 26 and/or is disposed between the channel layers 22, may include or be formed of a slope side or an inclined surface so that a width of the gate structure 30 widens when approaching the rear side from the front side (e.g. a width that increases towards the bottom of the structure). This is because the second separator 10b formed by etching the stacking structure 20s (refer to FIG. 3A) is formed from the upper portion of the support member 10. However, example embodiments are not limited thereto, and numerous variations are possible.

The gate structure 30 extending in the second direction (e.g., the Y-axis direction in the drawing) crossing the channel layer 22 and traversing the channel layers 22 may be disposed on the channel layers 22. The gate structures 30 may be spaced apart from each other in the first direction (e.g., the X-axis direction in the drawing).

The gate structure 30 may include a gate electrode 32, a gate insulating layer 34, a gate spacer 36, and a gate capping layer 38.

The gate electrode 32 may surround the channel layers 22 and may be disposed on the active region 20 including the channel layers 22. The gate electrodes 32 may be separated from each other in the second direction (e.g., the Y-axis direction in the drawing) according to a circuit configuration of the semiconductor device 100. For example, an additional gate separator may be formed on the gate electrode 32, and the gate electrode 32 may be divided into a plurality of gate electrodes that are arranged in the second direction.

A gate insulating layer 34 may be disposed between the gate electrode 32 and the channel layer 22. In an example embodiment, the gate insulating layer 34 may be disposed between the channel layer 22 and the gate electrode 32 in the active region 20, and may be further disposed between the gate electrode 32 and the gate spacer 36.

The gate spacer 36 may be disposed on a lateral side of the gate electrode 32 to insulate the gate electrode 32 from the source and drain regions 40, and/or the source and drain electrodes 50. For example, the gate spacer 36 may be disposed on the lateral side of the gate electrode 32 disposed on the active region 20, and may not be disposed on the lateral side of the channel layer 22 forming the active region 20. The gate spacer 36 may extend in the second direction (e.g., the Y-axis direction in the drawing) on respective lateral sides of the gate electrode 32 in the first direction (e.g., the X-axis direction in the drawing).

A gate capping layer 38 may be disposed on the gate electrode 32. FIG. 2 illustrates that the gate spacer 36 is disposed on the lateral side of the gate capping layer 38. In some example embodiments, the gate capping layer 38 may be disposed on the gate spacer 36. In an example embodiment, the front side of the gate capping layer 38 may be disposed on the same plane as the front side of the source and drain electrodes 50 or the insulation layer 44. However, example embodiments are not limited thereto. Therefore, the front side of the gate capping layer 38 may be disposed on a plane that is different from the front side of the source and drain electrodes 50 or the insulation layer 44.

The gate electrode 32 may include a conductive material. For example, the gate electrode 32 may include at least one of metal, metal alloy, metal nitride, metal silicide, and a doped semiconductor material. Here, the metal or the metal alloy included in the gate electrode 32 may include at least one of tungsten, molybdenum, aluminum, copper, and cobalt, and the metal nitride included in the gate electrode 32 may include at least one of a tungsten nitride, a molybdenum nitride, a titanium nitride, and a tantalum nitride. The gate electrode 32 may further include metal oxide or metal oxynitride in which the above material is oxidized, or the gate electrode 32 may include a plurality of layers.

The gate insulating layer 34 may include oxide, nitride, or a high dielectric constant material. The high dielectric constant material may represent a dielectric material with a dielectric constant that is higher than that of the silicon oxide. For example, the gate insulating layer 34 may include at least one of silicon oxide, silicon nitride, silicon oxynitride, hafnium oxide, aluminum oxide, and tantalum oxide. The gate insulating layer 34 may include a plurality of insulation layers.

The gate spacer 36 may include at least one of silicon oxide, silicon nitride, and silicon oxynitride, or may further include carbon in addition. For example, the gate spacer 36 may be made of a low dielectric constant material. The gate spacer 36 may include a plurality of layers. The gate capping layer 38 may include at least one of silicon oxide, silicon nitride, and silicon oxynitride.

However, example embodiments are not limited to the above materials, and the gate electrode 32, the gate insulating layer 34, the gate spacer 36, and the gate capping layer 38 may be made of any of various materials or have any of various structures.

The source and drain regions 40 may be disposed on respective sides of the active region 20 and/or the gate structure 30. At this time, the source and drain regions 40 may be disposed adjacent to corresponding sides of the active region 20 in the first direction (e.g., the X-axis direction in the drawing), respectively, and may configure a source region or a drain region of a transistor.

The source and drain regions 40 may include or be formed of an epitaxial layer formed by a selective epitaxial growth (SEG) process in a recessed portion of the active region 20. Although the source and drain regions 40 is illustrated to have an angular shape, example embodiments are not limited thereto. The source and drawing regions 40 may have any of various shapes such as a polygonal shape, a circular shape, an elliptical shape, and a rounded shape.

For example, the source and drain regions 40 may include at least one of silicon, silicon-germanium, and silicon carbide (SiC), and may further include impurities such as arsenic (As) or phosphorus (P). In some example embodiments, the source and drain regions 40 may include a plurality of portions having different compositions. However, example embodiments are not limited to the above materials, and the source and drain regions 40 may be made of any of various materials or have any of various structures.

An insulation layer 44 covering at least a part of the source and drain regions 40 may be disposed on the substrate insulation layer 14. An etch stopper (not shown) may be further disposed between the source and drain regions 40 and the insulation layer 44. The insulation layer 44 may, for example, include at least one of silicon oxide, silicon nitride, silicon oxynitride, and a low dielectric constant material. However, example embodiments are not limited to the above materials, and the insulation layer 44 may be made of any of various materials or have any of various structures.

The source and drain electrodes 50 may pass through the insulation layer 44 and may be connected to the source and drain regions 40, respectively. The source and drain electrodes 50 may be disposed on corresponding sides of the gate structure 30 in the first direction (e.g., the X-axis direction in the drawing), respectively, and may extend in the second direction (the Y-axis direction in the drawing). The source and drain electrodes 50 may be separated by an insulator or an insulating portion 54 in the second direction to implement a desired circuit configuration.

For example, the insulator 54 may be disposed in a center region and/or a border region of the standard cell SC so that the source and drain electrodes 50 may be separated. For example, the insulator 54 may be disposed to correspond to the center region of the standard cell SC or the separating insulator 14a to separate source electrodes, and may be disposed at the boundary region of the standard cell SC to separate drain electrodes. However, example embodiments are not limited thereto, and a position and a shape of the insulator 54 may be variously modified in consideration of the desired circuit configuration.

In an example embodiment, the source and drain electrodes 50 may include a main body portion 50a disposed on the insulation layer 44, and an extending portion 50b for passing through at least part of the insulation layer 44 and/or the upper insulator 14b to connect the main body portion 50a and a penetration connector or a penetration connection portion 52. By the extending portion 50b, the source and drain electrodes 50 may be stably connected to the power wire 12 through the penetration connector 52.

At this time, by forming the insulator 54 to have a large depth so that a rear side of the insulator 54 is disposed lower than a rear side of the extending portion 50b, an electrical connection at an unwanted portion may be effectively blocked or prevented. A lateral side of the extending portion 50b may include or be formed of a slope side or an inclined surface so that a width of the extending portion 50b narrows when approaching the rear side from the front side (e.g. in a negative Z direction). This is because an opening portion for forming the extending portion 50b is formed by an etching at the upper side. However, example embodiments are not limited to this and numerous variations are possible.

FIG. 2 illustrates that a boundary between the penetration connector 52 and the extending portion 50b of the source and drain electrodes 50 is positioned lower than an upper side of the upper insulator 14b. However, example embodiments are not limited to this. As another example embodiment, a boundary between the penetration connector 52 and the extending portion 50b of the source and drain electrodes 50 may be disposed higher than the upper side of the upper insulator 14b.

Also, unlike what is shown in FIG. 2, according to an example embodiment, the source and drain electrodes 50 may not include the extending portion 50b. When the source and drain electrodes 50 includes a main body portion 50a, the penetration connector 52 may be formed up to a region of the extending portion 50b of FIG. 2 and may be connected to the main body portion 50a.

The source and drain electrodes 50 may be configured as a single layer or a plurality of layers. The source and drain electrodes 50 may include any of various conductive materials. For example, the source and drain electrodes 50 may include at least one of metal, metal alloy, metal nitride, metal silicide, and a doped semiconductor material. Here, the metal or metal alloy included in the source and drain electrodes 50 may include at least one of tungsten, molybdenum, aluminum, copper, cobalt, titanium, and tantalum, and the metal nitride included in the source and drain electrodes 50 may include at least one of tungsten nitride, molybdenum nitride, titanium nitride, and tantalum nitride. The source and drain electrodes 50 may further include metal oxide or metal oxynitride in which the above metal material is oxidized, or may include a plurality of layers. However, example embodiments are not limited to the above material, and the source and drain electrodes 50 may be made of any of various materials or may have any of various structures.

At least one (e.g., a source electrode) of the source and drain electrodes 50 may be connected to the power wire 12 through the penetration connector 52. The penetration connector 52 may penetrate an insulating portion disposed on the separating insulator 14a and/or the power wire 12 and made of an insulating material. Here, the insulating portion may represent at least a portion of the upper insulator 14b of the substrate insulation layer 14 and/or the insulation layer 44.

In an example embodiment, as the power wire 12 constitutes at least a part of the support member 10, the penetration connector 52 does not penetrate the support member 10 and may penetrate the insulating portion such as the substrate insulation layer 14 or the insulation layer 44 to be connected to the power wire 12. By this, a power transmitting path between the power wire 12 for applying a power voltage and the source and drain regions 40 may be reduced. According to this, it is possible to prevent or reduce a voltage drop (IR drop) that may occur due to a long power transmitting path. When a size of the semiconductor device 100 is reduced and a wire pitch is reduced, the voltage drop may have a great effect on performance of the semiconductor device 100. According to the present example embodiment, the voltage drop may be effectively reduced or prevented.

For example, the penetration connector 52 may be disposed at the boundary region of the standard cell SC. The penetration connector 52 may be stably disposed at a region in which the first separator 10a or the separating insulator 14a, which disposed at the center region of the standard cell SC, is not positioned. However, example embodiments are not limited thereto, and a position of penetration connector 52 may be variously modified.

The penetration connector 52 may be made of any various conductive materials. For example, the penetration connector 52 may include at least one of tungsten, molybdenum, aluminum, copper, and cobalt, or an alloy including the same.

In an example embodiment, the penetration connector 52 may be made of a material that is different from that of the source and drain electrodes 50. This is because the source and drain electrodes 50 has a relatively large area and the penetration connector 52 has an island shape and has a relatively narrow area. For example, a material of the penetration connector 52 may have a better filling property, a high electrical conductivity and low resistance than a material of the source and drain electrodes 50.

However, example embodiments are not limited thereto. As another example embodiment, the penetration connector 52 may be made of the same material as the source and drain electrodes 50. That is, FIG. 2 illustrates that the penetration connector 52 is provided separately from the source and drain electrodes 50, but example embodiments are not limited thereto. In some example embodiments, the penetration connector 52 and the source and drain electrodes 50 may be formed together in the same process using the same material and may have an integrated structure indistinguishable from each other.

In an example embodiment, a lateral side of the penetration connector 52 may include or be formed of a slope side or an inclined surface so that a width of the penetration connector 52 narrows when approaching a lower portion from an upper portion (e.g. moving in a negative Z direction). This is because a penetration portion for forming the penetration connector 52 is formed by etching at the upper side. However, example embodiments are not limited to this and numerous variations are possible.

The front wire portion 60 may be disposed on a semiconductor device portion disposed on the front side of the support member 10. Here, the semiconductor device portion may represent a portion including an active region 20, a gate structure 30, an insulation layer 44, source and drain regions 40, and a source and drain electrodes 50. The front wire portion 60 may include front wire layers 62 disposed with an interlayer insulating layer 64 interposed therebetween, and a contact via 66 for electrically connecting the front wire layers 62 to each other. The front wire layers 62 may include a first wire layer 62a configuring a signal wire 62s and one or a plurality of second wire layers 62b disposed on the first wire layer 62a. For example, the signal wire 62s or the first wire layer 62a may be a wire for transmission of signals between neighboring standard cells SC, and a portion of the second wire layer 62b may be connected to the gate electrode 32.

FIG. 2 illustrates that the signal wire 62s is connected to at least one of the source and drain regions 40 (e.g., a drain region) by a contact via 62c, but example embodiments are not limited thereto.

For example, the interlayer insulating layer 64 may include at least one of silicon oxide, silicon nitride, silicon oxynitride, and a low dielectric constant material. The front wire layers 62 and/or the contact vias 62c and 66 may include at least one of metal, metal alloy, metal nitride, and metal silicide. However, example embodiments are not limited to the disclosed materials of the interlayer insulating layer 64, the front wire layer 62, and the contact vias 62c and 66.

In an example embodiment, in a plan view, the signal wire 62s may overlap the separating insulator 14a disposed at the center region of the standard cell SC. For example, when based on the respective standard cells SC in a plan view, a region in which the signal wire 62s is formed (e.g., a region between external edges of one or a plurality of signal wires 62s corresponding to the respective standard cells SC) in the second direction (e.g., the Y-axis direction in the drawing) may be disposed inside edges on respective sides (e.g., within two opposite sides) of a region in which the active regions 20 are disposed. That is, when based on the respective standard cells SC in a plan view, the signal wire 62s may be disposed to overlap the active regions 20 or the separating insulator 14a in the third direction (Z direction), and the signal wire 62s may not be disposed at other regions.

However, example embodiments are not limited thereto. Therefore, in a structure in which a rear wire portion 70 is provided as in the example embodiment, the signal wire 62s may be freely disposed at an entire region including the center region and the border region of the standard cell SC, thereby increasing design freedom. Therefore, a position of the signal wire 62s may be changed in many ways.

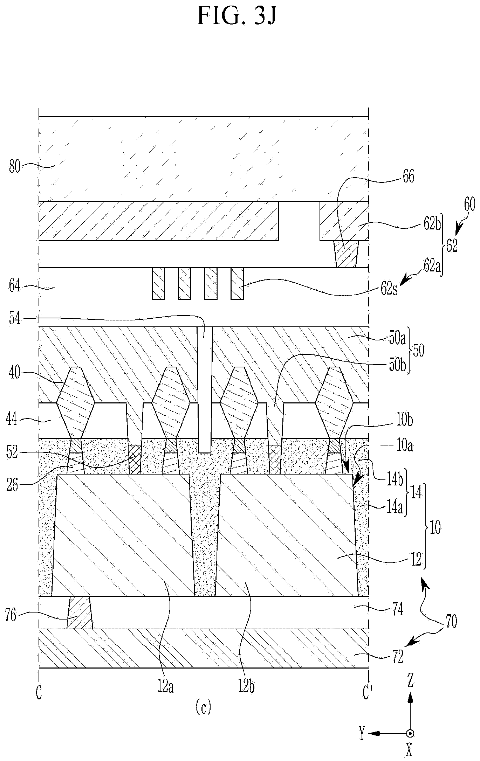

Although not shown, a carrier substrate 80 (refer to FIG. 3J) may be provided on the front wire portion 60 depending on example embodiments. However, the carrier substrate 80 may not be provided and various modifications may be possible.

A rear wire portion 70 may be disposed at a rear side of the support member 10. That the rear wire portion 70 is disposed at the rear side of the support member 10 may include not only being located on the rear side of the support member 10 but also forming a part of a lower portion of the support member 10. For example, the rear wire portion 70 may include a power wire 12 constituting a part of the support member 10, one or a plurality of rear wire layers 72, an interlayer insulating layer 74 between the power wire 12 and the one or the plurality of rear wire layers 72, and a contact via 76 for electrically connecting the power wire 12 and the one or the plurality of rear wire layers 72. The rear wire portion 70 may be a back side power delivery network (BSPDN) for supplying a power voltage to the source and drain electrodes 50.

For example, the interlayer insulating layer 74 may include at least one of silicon oxide, silicon nitride, silicon oxynitride, and a low dielectric constant material. The rear wire layer 72 and/or the contact via 76 may include at least one of a metal (e.g., copper), metal alloy, metal nitride, and metal silicide. However, materials of the interlayer insulating layer 74, the rear wire layer 72, and the contact via 76 according to example embodiments are not limited thereto.

According to the example embodiment, the support member 10 includes or is formed of the substrate insulation layer 14 and the power wire 12 to simplify a structure of the semiconductor device 100 and reduce a size of the semiconductor device 100, and reduce or minimize a power transmitting path and prevent or reduce voltage drop. The power wire 12 may be formed by a self-aligning process using the separating insulator 14a, and a process for manufacturing the semiconductor device 100 may be simplified.

By this, performance of the semiconductor device 100 may be increased and productivity of the semiconductor device 100 may be increased.

An example of a method for manufacturing a semiconductor device 100 will now be described with reference to FIG. 1, FIG. 2, and FIG. 3A to FIG. 3J. The portions that have already been described will be omitted, and portions that are not mentioned will be described in detail.

FIG. 3A to FIG. 3J show a processing diagram of a method of manufacturing the semiconductor device 100 shown in FIG. 1. Referring to FIG. 3A to FIG. 3J, (a) shows a cross-sectional view with respect to a line A-A' of FIG. 1, (b) shows a cross-sectional view with respect to a line B-B' of FIG. 1, and (c) shows a cross-sectional view with respect to a line C-C' of FIG. 1.

As shown in FIG. 3A, a stacking structure body 20s including an etch stopper (an etch stopping layer) 24a, and channel layers 22 and sacrificial layers 24b that are alternately stacked may be formed on a front side of a substrate 12s. Here, the substrate 12s and the stacking structure body 20s formed on the substrate 12s may be referred to as a support structure.

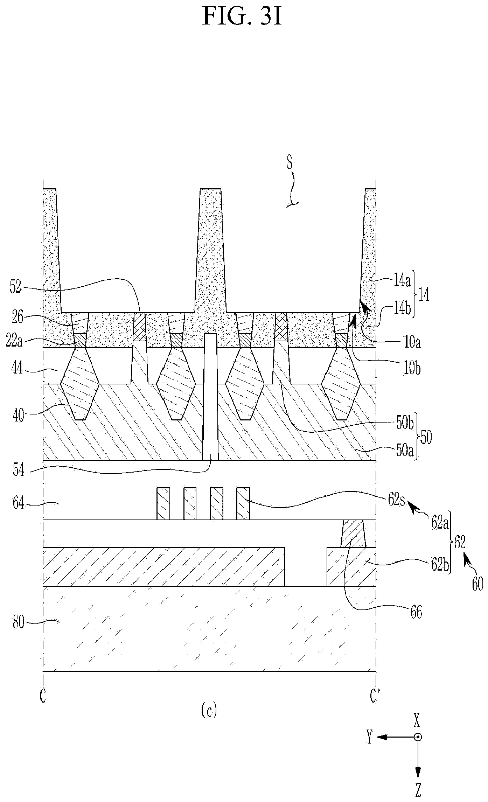

The substrate 12s may include or be formed of a semiconductor substrate including a semiconductor material. For example, the substrate 12s may include at least one of a group IV semiconductor, a group III-V compound semiconductor, and a group II-VI compound semiconductor. For example, the substrate 12s may include Si, Ge, SiGe, SiC, GaAs, InAs, or InP. The substrate 12s may be removed in a subsequent process to provide a space in which a power wire 12 (refer to FIG. 3I) will be disposed.

In an example embodiment, the etch stopper 24a, the channel layers 22, and the sacrificial layers 24b may be formed by an epitaxial growth.

The channel layer 22 may include a semiconductor material. The channel layer 22 may include a first channel layer 22a disposed between the etch stopper 24a and the sacrificial layer 24b on the etch stopper 24a, and a second channel layer 22b disposed between the two sacrificial layers 24b and/or on the sacrificial layer 24b.

An etching process in a subsequent process for removing the substrate 12s may be stopped by the etch stopper 24a, and the etch stopper 24a may be removed in a subsequent process to provide a space in which a rear insulation layer 26 (refer to FIG. 3I) will be disposed. The sacrificial layer 24b may be removed in a subsequent process to provide a space in which the gate insulating layer 34 and the gate electrode 32 will be disposed. The etch stopper 24a and/or sacrificial layer 24b may include a material having etch selectivity with the channel layer 22 for an etching material for etching the channel layer 22. For example, the channel layer 22 may include silicon, and the etch stopper 24a and/or the sacrificial layer 24b may include silicon germanium.

In an example embodiment, the etch stopper 24a may be thicker than the sacrificial layer 24b, and the first channel layer 22a disposed between the etch stopper 24a and the sacrificial layer 24b may be thicker than the second channel layer 22b disposed between the neighboring sacrificial layers 24b. This is to stably protect or maintain the active region 20 (refer to FIG. 3B) in the subsequent process for removing the substrate 12s. However, example embodiments are not limited thereto, and the thicknesses of the etch stopper 24a, the sacrificial layer 24b, and the first and second channel layers 22a and 22b may be variously modified.

As shown in FIG. 3B, the stacking structure body 20s and the substrate 12s may be partially removed to form a first separator 10a and a second separator 10b, and the first separator 10a and the second separator 10b may be filled with an insulating material to form a substrate insulation layer 14 including a separating insulator 14a and an upper insulator 14b.

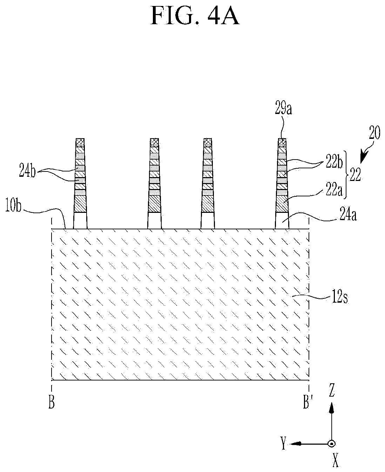

At this time, the first separator 10a and the second separator 10b may be formed by performing the etching process at the front side. The substrate insulation layer 14 may be formed after or during the process for forming the first separator 10a and/or the second separator 10b. The first separator 10a, the second separator 10b, and the substrate insulation layer 14 may be formed by any of various process sequences, one example of which will be shown later in detail with reference to FIG. 4A to FIG. 4E.

As the first separator 10a is formed by the etching process at the front side of the stacking structure body 20s, a lateral side of the first separator 10a may include or be formed of a slope side or an inclined surface so that a width of the first separator 10a gradually narrows approaching a rear side of the support member 10 from a front side of the support member 10 in a cross-section (e.g., a cross-section along a YZ plane of the drawing) that is perpendicular to the first direction. As the second separator 10b is formed by the etching process at the front side of the stacking structure body 20s, a lateral side of the stacking structure body 20s (e.g., the active region 20, the sacrificial layer 24b, and the etch stopper 24a) may include or be formed of a slope side or an inclined surface so that a width of the stacking structure body 20s widens approaching the rear side from the front side in the cross-section (e.g., a cross-section along the YZ plane of the drawing) that is perpendicular to the first direction.

In this case, the second separator 10b may represent a portion formed by etching the stacking structure body 20s, and the first separator 10a may represent a portion formed by etching the stacking structure body 20s and the substrate 12s. At this time, the first separator 10a may be formed at a part of the substrate 12s in a thickness direction, and another part of the substrate 12s may be disposed at a lower portion of the first separator 10a. By the another part of the substrate 12s being disposed at the lower portion of the first separator 10a, the substrate 12s may have a stable structure in a manufacturing process.

In an example embodiment, a rear side of the second separator 10b is disposed on the same plane as a rear side of the etch stopper 24a. Thus, the stacking structure body 20s may be completely removed by the second separator 10b at an upper portion of the substrate 12s to be replaced with the power wire 12, thereby stably realizing the insulation and separation structure. Example embodiments are not limited to this, and the rear side of the second separator 10b may be disposed between the rear side and the upper surface of the etch stopper 24a, may be disposed on the same plane of the upper side of the etch stopper 24a, or may be disposed inside the substrate 12s.

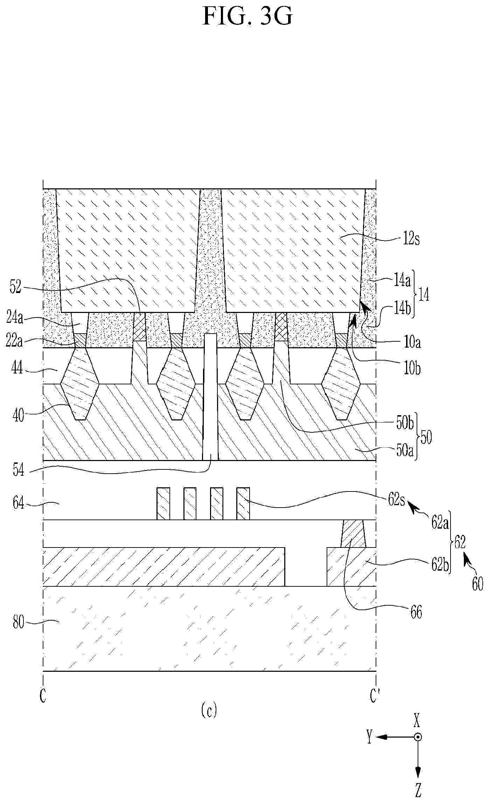

For example, a depth D of the first separator 10a may be less than a height (H) from the front side of the substrate 12s to the front side of the active region 20. The rear side of the first separator 10a may function as an etch stopping side in the process for partially removing the rear side of the substrate 12s to be described with reference to FIG. 3G. Accordingly, the depth D of the first separator 10a corresponds to the thickness of the power wire 12, and the thickness of the power wire 12 may be easily adjusted by adjusting the depth D of the first separator 10a.

The substrate insulation layer 14 may be disposed on the substrate 12s and may fill the first separator 10a and the second separator 10b. For example, the front side of the substrate insulation layer 14 may be disposed below the front side or the uppermost portion of the first channel layer 22a. However, example embodiments are not limited thereto, and the front side of the substrate insulation layer 14 may be disposed on the same plane as the front side or the uppermost portion of the first channel layer 22a. Other numerous variations are possible.

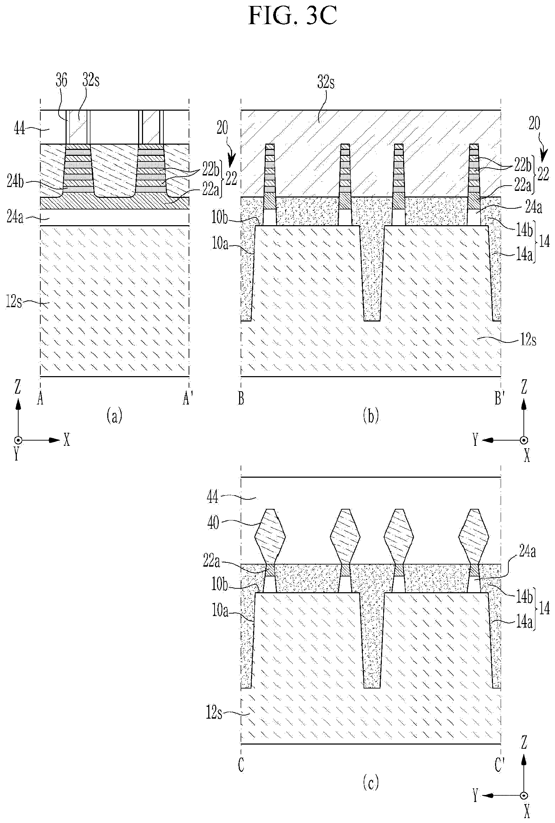

As shown in FIG. 3C, a dummy gate 32s may be formed on the active region 20, and source and drain regions 40 and an insulation layer 44 covering the same may be formed.

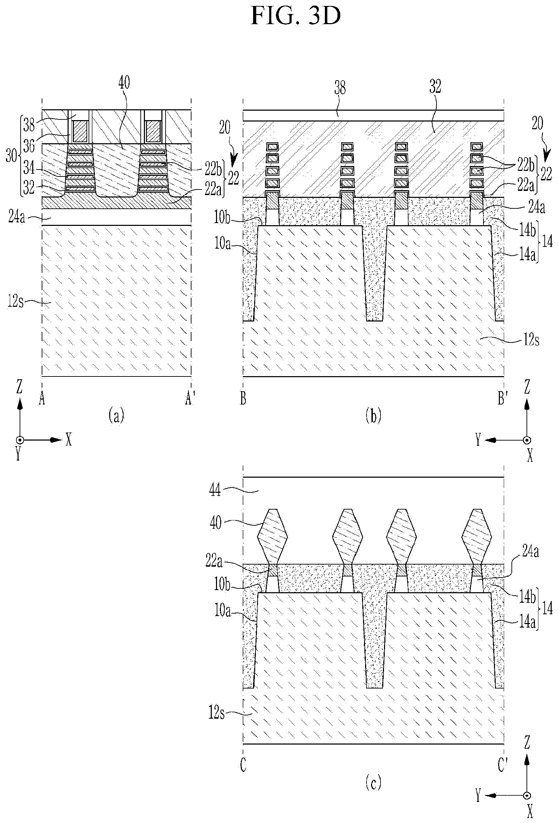

First, the dummy gate 32s may be formed on the active region 20. The dummy gate 32s may be a layer that will be replaced with a gate electrode 32 (refer to FIG. 3D) in a subsequent process. For example, the dummy gate 32s may be made of polysilicon. Depending on example embodiments, a gate spacer 36 may be further formed on respective sides of the dummy gate 32s.

In an example embodiment, the dummy gate 32s and/or the gate spacer 36 may extend in a direction traversing a direction in which the active region 20 extends. For example, the dummy gate 32s and/or the gate spacer 36 may extend in the second direction (e.g., the Y-axis direction in the drawing), and a plurality of dummy gate 32s and/or a plurality of gate spacers 36 may be spaced from each other in the first direction (the X-axis direction in the drawing).

By the etching process using the dummy gate 32s and/or the gate spacer 36 as masks, the active region 20 may be etched, and a part of an upper side of the first channel layer 22a may be exposed at an outside of the dummy gate 32s and the gate spacer 36.

Depending on example embodiments, a portion of the exposed sacrificial layer 24b may be removed from the lateral sides of the dummy gate 32s and the gate spacer 36 to form an interior spacer space, and the interior spacer space may be filled with an insulating material to form an interior spacer (not shown). The interior spacer may be made of the same material as the gate spacer 36, and example embodiments are not limited thereto.

The source and drain regions 40 may be formed from the exposed upper side of the first channel layer 22a by using a selective epitaxial growth process. The source and drain regions 40 may have any of various thicknesses. For example, a front side of the source and drain regions 40 may be disposed higher than the front side of the active region 20, or a front side of the source and drain regions 40 may be disposed on the same plane as the front side of the active region 20.

The insulation layer 44 may be formed outside the gate spacer 36 to cover the source and drain regions 40. In an example embodiment, a part of the insulation layer 44 may be formed before the source and drain regions 40 are formed. In this case, the source and drain regions 40 may grow and be formed in a space between the insulation layer 44. However, example embodiments are not limited thereto, and an order for processing the source and drain regions 40 and the insulation layer 44 is changeable in many ways. Other numerous variations are possible.

As shown in FIG. 3D, the dummy gate 32s (refer to FIG. 3C) may be replaced with a gate electrode 32, and a gate structure 30 may be formed.

First, the dummy gate 32s may be removed. Here, an etching material for selectively etching the dummy gate 32s while not etching the source and drain regions 40 and the gate spacer 36 may be used.

When the dummy gate 32s is removed, the channel layer 22 and the sacrificial layer 24b (refer to FIG. 3C) disposed at a lower portion of the dummy gate 32s may be exposed to an outside. The sacrificial layer 24b exposed to the outside may be selectively removed by using an etching process. In this instance, the etch stopper 24a is disposed at the lower portion of the substrate insulation layer 14 and is not exposed to the outside, and thus, the etch stopper 24a may not be removed but may remain.

A gate insulating layer 34 and a gate electrode 32 may be formed in a space from which the sacrificial layer 24b is removed. The gate insulating layer 34 may be conformally formed on a surface exposed by the space from which the sacrificial layer 24b is removed. The gate electrode 32 may fill the space on the gate insulating layer 34. The gate insulating layer 34 or the gate electrode 32 may be formed by an atomic layer deposition (ALD) process or a chemical vapor deposition (CVD) process. A gate capping layer 38 may be formed on the gate insulating layer 34 and/or the gate electrode 32 disposed on the active region 20.

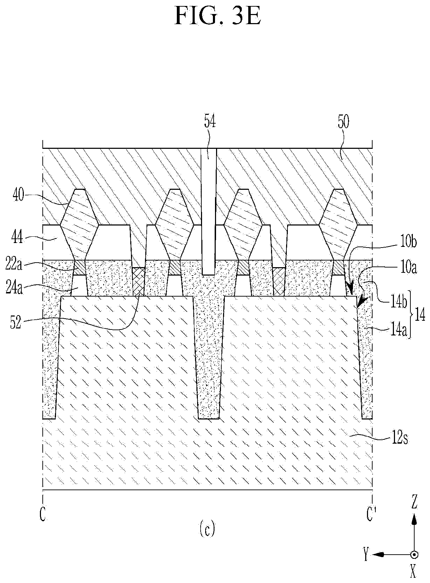

As shown in FIG. 3E, source and drain electrodes 50 and a penetration connector 52 connected to the source and drain regions 40 may be formed, and an insulator 54 for insulating the source and drain electrodes 50 may be formed.

In this instance, the insulator 54 may be formed and the source and drain electrodes 50 and then the penetration connector 52 may be formed, or the source and drain electrodes 50 and the penetration connector 52 may be formed and then the insulator 54 may be formed.

For example, an etching portion for forming an insulator 54 may be formed at the insulation layer 44 and/or the upper insulator 14b, and an insulating material may be filled in the etching portion to form the insulator 54.

For example, etching portions for forming source and drain electrodes 50 and a penetration connector 52 may be formed at the insulation layer 44, and a conductive material may be filled in the etching portions to form the source and drain electrodes 50 and the penetration connector 52.

For example, first and second etching portions for forming the source and drain electrodes 50 and the penetration connector 52 may be formed at the insulation layer 44. The second etching portion for forming the penetration connector 52 may extend to the front side of the substrate 12s from the first etching portion. The second etching portion may be filled with a conductive material to form the penetration connector 52, and then, the first etching portion may be filled with a conductive material to form the source and drain electrodes 50 by an additional process. In some example embodiments, the first and second etching portions may be filled with a conductive material to form the penetration connector 52 and the source and drain electrodes 50 in the same process. The penetration connector 52 and/or the source and drain electrodes 50 may be formed by an atomic layer deposition process, a chemical vapor deposition (CVD) process, a physical vapor deposition (PVD) process, or so on.

However, example embodiments are not limited thereto, and the process for forming the source and drain electrodes 50, the penetration connector 52, and the insulator 54 are changeable in many ways.

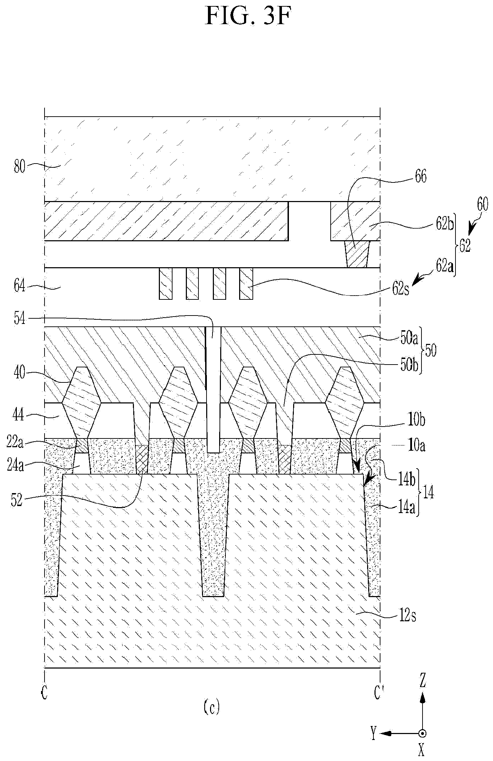

As shown in FIG. 3F, a front wire portion 60 including a signal wire 62s may be formed, and a carrier substrate 80 may be bonded on the front wire portion 60.

For example, the front wire portion 60 may be formed by forming a front wire layer 62 including a first wire layer 62a including the signal wire 62s and a second wire layer 62b, an interlayer insulating layer 64, contact vias 66 and 62c (refer to FIG. 2). Any of various processes may be applied to the process for forming the front wire layer 62, the interlayer insulating layer 64, and the contact vias 66 and 62c, and the process for bonding the carrier substrate 80.

As shown in FIG. 3G, the substrate 12s may be removed up to a rear side of the first separator 10a by performing a thinning process for partially removing a rear side portion of the substrate 12s in a thickness direction in a state that a rear portion of the substrate 12s is positioned at the top (e.g. rotated by 180 degrees). For example, a chemical mechanical polishing process may be used, but example embodiments are not limited thereto.

The etching is not performed smoothly at a part where the first separator 10a is provided. Thus, the rear side of the first separator 10a may function as an etch stopping side or an etch stopping surface. Accordingly, the substrate 12s may be stably removed up to the rear side of the first separator 10a.

As shown in FIG. 3H, a space portion S may be formed by removing the substrate 12s (refer to FIG. 3G) disposed between the separating insulator 14a (e.g. disposed between the first separators 10a) through etching the substrate 12s. The space portion S may be formed by the etching process using an etching material for selectively etching the substrate 12s. For example, a lateral side of the space portion S may include or be formed of a slope side or an inclined surface so that a width of the space portion widens when approaching a rear side from a front side.

At this time, a rear side of the etch stopper 24a positioned at a lower portion of the first channel layer 22a may be exposed through the space portion S.

As shown in FIG. 3I, the etch stopper 24a (refer to FIG. 3H) exposed through the space portion S may be removed, and an insulating material may be filled in the portion from which the etch stopper 24a is removed to form a rear insulation layer 26. As another example embodiment, when the etch stopper 24a is not separately provided, the active region 20 may be removed to a point higher than the rear side of the second separator 10b, and an insulating material is filled in the portion from which the active region 20 is removed to form the rear insulation layer 26.

As shown in FIG. 3J, (in which the carrier substrate 80 is once again at the top) a power wire 12 may be formed by filling a conductive material in the space portion S. The rear wire portion 70, which includes the power wire 12, may be formed by additionally forming a rear wire layer 72, an interlayer insulating layer 74, and a contact via 76.

For example, the power wire 12 may be formed by filling a conductive material to fill the space portion S and performing a planarization process. For example, the planarization process may be performed by a chemical mechanical etching process.

As the substrate 12s is removed and the power wire 12 is formed in the space portion S, the power wire 12 may be formed by a self-aligning process. By this, there is no need to perform an additional patterning process, and an aligning process for forming the power wire 12, thereby simplifying the manufacturing process. In the conventional art, if a power wire is disposed at a rear side, there is a difficulty in performing a process for aligning source and drain electrodes and a power wire and a patterning the source and drain electrodes and/or the power wire. On the other hand, in the example embodiment, this difficulty may be prevented or mitigated by the self-aligning process.

As the power wire 12 is formed by filling a conductive material in the space portion S disposed between the separating insulators 14a and having a large size, the power wire 12 may be stably formed. As described above, in a cross-section (a YZ plane in the drawing) that is perpendicular to the first direction (the X-axis direction in the drawing), a lateral side, which is a border between the separating insulator 14a and the substrate 12s, may include or be formed of a slope side or an inclined surface so that a width of the substrate 12s gradually increases when approaching the rear side from the front side. Hence, in the process for filling the conductive material to form the power wire 12, the conductive material may be filled from the rear side having a relatively large size. Accordingly, the space portion S has a positive slope, and thus, voids may be mitigated or prevented from being generated in the power wire 12.

Any of various processes may be applied as a process for forming the rear wire layer 72, the interlayer insulating layer 74, the contact via 76, or so on.

According to the disclosed example embodiment, the process for manufacturing the semiconductor device 100 may be simplified by forming the power wire 12 through the self-aligning process. Thus, productivity of the semiconductor device 100 having excellent performance may be improved.

An example of a process for forming the first separator 10a, the second separator 10b, and the substrate insulation layer 14 shown in FIG. 3B will now be described with reference to FIG. 4A to FIG. 4E. FIG. 4A to FIG. 4E show a portion that corresponds to (b) of FIG. 3A or FIG. 3B.

As shown in FIG. 4A, a second separator 10b may be formed by etching a stacking structure body 20s (refer to FIG. 3A) through an etching process using a first hard mask layer 29a at a front side. As the etching process, any of various processes, such as a dry etching, may be applied, and detailed descriptions thereof will be omitted.

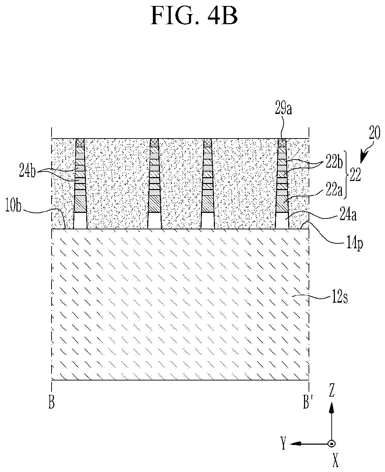

As shown in FIG. 4B, a first preliminary insulation layer 14p for filling the second separator 10b may be formed. The first preliminary insulation layer 14p may be formed by forming an insulating material to fill the second separator 10b and then performing a chemical mechanical polishing in order for the insulating material to be the same plane as a front side of the first hard mask layer 29a or an active region 20.

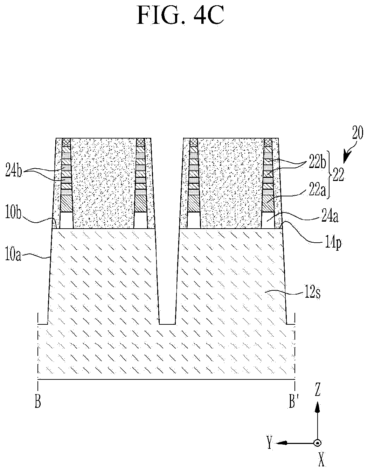

As shown in FIG. 4C, a first separator 10a may be formed by etching the first preliminary insulation layer 14p and a part of the substrate 12s according to an etching process at a front side. For example, the first separator 10a may be formed by forming a second mask layer (not shown) on the first hard mask layer 29a, patterning the second mask layer, and performing an etching process using a dry etching. However, the etching process may be modified in various ways.

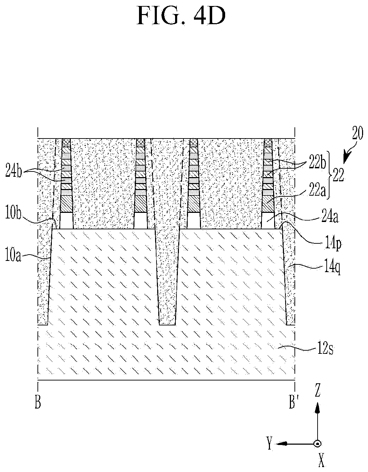

As shown in FIG. 4D, a second preliminary insulation layer 14q for filling the first separator 10a may be formed. The second preliminary insulation layer 14q may be formed by forming an insulating material to fill the first separator 10a and then performing a chemical mechanical polishing in order for the insulating material to be the same plane as the front side of the first hard mask layer 29a or the active region 20. The second preliminary insulation layer 14q may include or be formed of the same material as the first preliminary insulation layer 14p. Depending on example embodiments, the second preliminary insulation layer 14q may include or be formed of a material that is different from the first preliminary insulation layer 14p.

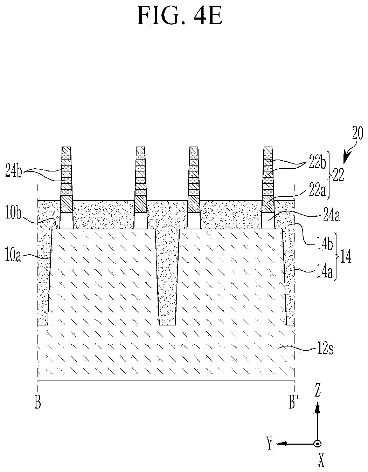

As shown in FIG. 4E, the substrate insulation layer 14 having a separating insulator 14a and an upper insulator 14b may be formed by etching the first and second preliminary insulation layers 14p and 14p (refer to FIG. 4D). An etch back process or the like may be applied as a process for etching the first and second preliminary insulation layers 14p and 14p. The first hard master layer 29a (refer to FIG. 4D) may be removed in the process for removing the first and second preliminary insulation layers 14p and 14q or before or after the corresponding process. As any of various processes may be applied to this, a detailed description thereof will be omitted.

In an example embodiment, the substrate insulation layer 14 may be formed in order of the first separator 10a, the first preliminary insulation layer 14p, the second separator 10b, and the second preliminary insulation layer 14q. Accordingly, the substrate insulation layer 14 having the separating insulator 14a and the upper insulator 14b may be stably formed. However, example embodiments are not limited thereto, and the process sequence described above may be modified in various ways.

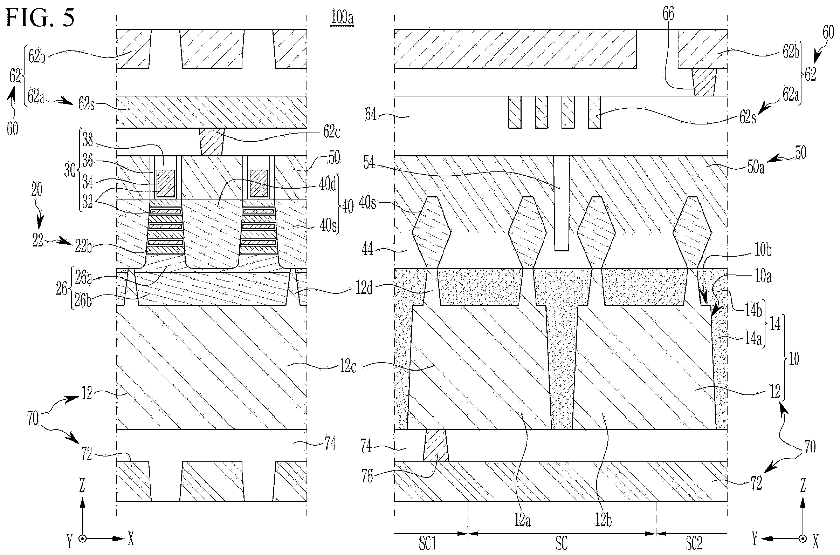

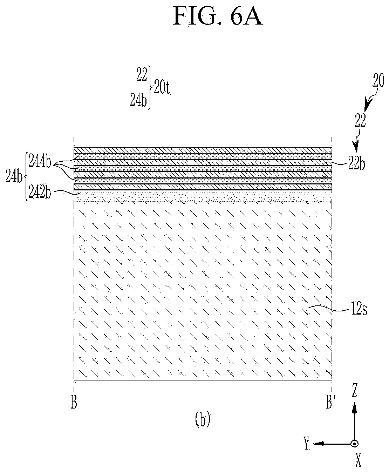

A semiconductor device according to another example embodiment that has differences from the above-described example embodiment and will be described in more detail with reference to FIG. 5 and FIG. 6A to FIG. 6H. Portion that are identical or extremely similar to those in the already described embodiment will not be described, and portions that are different to those already described will be described in detail.

FIG. 5 shows a cross-sectional view of a semiconductor device according to another example embodiment. FIG. 5 shows a portion that corresponds to a portion shown in FIG. 2.

Referring to FIG. 5, in a semiconductor device 100a according to an example embodiment, a power wire 12 (as described in FIG. 2) may further include a connector or a connecting portion 12d connected (e.g., directly contacted) to a rear side of at least one (e.g., a source region 40s) of source and drain regions 40.

In an example embodiment, a rear insulation layer 26 may be disposed between at least the active region 20 and the power wire 12 (e.g., a main body 12c of the power wire 12). For example, the rear insulation layer 26 may be disposed between the source and drain regions 40 and the power wire 12 (e.g., the main body 12c of the power wire 12).

For example, the rear insulation layer 26 may include a first rear insulation layer 26a and a second rear insulation layer 26b sequentially disposed at a lower portion of the active region 20. The first rear insulation layer 26a and the second rear insulation layer 26b may be formed by different processes or may have different materials or compositions. However, example embodiments are not limited thereto, and the first rear insulation layer 26a and the second rear insulation layer 26b may have the same material or composition and may constitute one layer indistinguishable from each other. Other numerous variations are possible. In this case, the rear insulation layer 26 may have a penetrating portion at a portion where the connector 12d is disposed.

In an example embodiment, the active region 20 may include a plurality of second channel layers 22b, and may not include a first channel layer 22a provided in the example embodiment with reference to FIG. 2. Accordingly, the active region 20 may be formed to correspond between the source and drain regions 40 in the first direction (the X direction in the drawing). Accordingly, a plurality of active regions 20 may be disposed apart from each other in the first direction, and a plurality of active regions 20 may be disposed apart from each other in the second direction. For example, the rear insulation layer 26 may be disposed at a region where the first channel layer 22a is positioned in the example embodiment with reference to FIG. 2, but example embodiments are not limited thereto.

In an example embodiment, the power wire 12 may include a main body 12c and a connector 12d. The main body 12c may be disposed at a space between a plurality of first separators 10a and have a shape of a plane (an XY plane of the drawing) extending in the first and second directions. The connector 12d may protrude from a front side of the main body 12c, pass through the rear insulation layer 26, and be connected to at least one of the source and drain regions 40. The connector 12d may protrude from a portion of the main body 12c and may have an area that is smaller than the area of the main body 12c. The main body 12c and the connector 12d of the power wire 12 may have an integrated structure. In other words, the main body 12c and the connector 12d may be formed together in the same process using the same material. However, example embodiments are not limited to this, and the main body 12c and the connector 12d may be formed separately or may include different materials.

In an example embodiment, the connector 12d may extend to and be connected to a rear side of a region (e.g., the source region 40s) of the source and drain regions 40 to be connected to the power wire 12. However, a position and a connection structure of the connector 12d may be variously modified.

As described, the power wire 12 is directly connected to the rear side of at least one (e.g., the source region 40s) of the source and drain regions 40 through the connector 12d, and thus, a penetration connector 52 (refer to FIG. 2) may not be provided. For example, the source and drain electrodes 50 may include or be formed of a main body portion 50a having a uniform thickness without including an extending portion 50b (refer to FIG. 2). Depending on a circuit configuration, an insulator 54 may be disposed at a center region and/or a border region of a standard cell SC, and the insulator 54 may be disposed at the insulation layer 44 without extending to an upper insulator 14b. However, example embodiments are not limited to this, and a shape of the source and drain electrodes 50 and a position of the insulator 54 may have numerous variations.

In an example embodiment, the separating insulator 14a may be disposed (extend) from a front side of the main body 12c of the power wire 12 to a rear side of the main body 12c of the power wire 12. The upper insulator 14b may be disposed from a front side of the substrate insulation layer 14 to the front side of the main body 12c of the power wire 12, or may be disposed from a front side of the connector 12d to a rear side of the connector 12d. As described, in the example embodiment, an entire portion of the substrate insulation layer 14, including the separating insulator 14a and the upper insulator 14b, and an entire portion of the power wire 12 may be disposed to correspond to each other.

An example of a method for manufacturing a semiconductor device 100a with the above-described structure will now be described in detail with reference to FIG. 5 and FIG. 6A to FIG. 6H. The portions that are described above and that are identical or similar to the descriptions provided with reference to FIG. 2 or FIG. 3A to FIG. 3I will not be described, and portions that are not described will be described in detail.

FIG. 6A to FIG. 6H show a processing diagram of a method for manufacturing the semiconductor device 100a shown in FIG. 5. Regarding FIG. 6A to FIG. 6H, (a) shows a cross-sectional diagram corresponding to the line A-A' of FIG. 1, (b) shows a cross-sectional diagram corresponding to the line B-B' of FIG. 1, and (c) shows a cross-sectional diagram corresponding to the line C-C' of FIG. 1.

As shown in FIG. 6A, a stacking structure body 20t including channel layers 22 and sacrificial layers 24b alternately stacked may be formed on a front side of the substrate 12s. Here, the substrate 12s and the stacking structure body 20t formed on the substrate 12s may be referred to as a support structure.

In an example embodiment, the channel layer 22 may include a plurality of second channel layers 22b. The sacrificial layers 24b may include a first sacrificial layer 242b disposed at a lowest portion, and one or a plurality of second sacrificial layers 244b disposed on the first sacrificial layer 242b.

Here, the first sacrificial layer 242b may have a material or a composition that is different from that of the second sacrificial layer 244b. For example, the first sacrificial layer 242b and the second sacrificial layer 244b may include silicon-germanium, and the germanium content of the first sacrificial layer 242b may be higher than the germanium content of the second sacrificial layer 244b. For example, a thickness of the first sacrificial layer 242b may be greater than a thickness of the second sacrificial layer 244b. However, example embodiments are not limited to the above-mentioned material, composition, and thickness of the first sacrificial layer 242b and/or the second sacrificial layer 244b. As another example, a thickness of the first sacrificial layer 242b may be equal to or less than a thickness of the second sacrificial layer 244b.

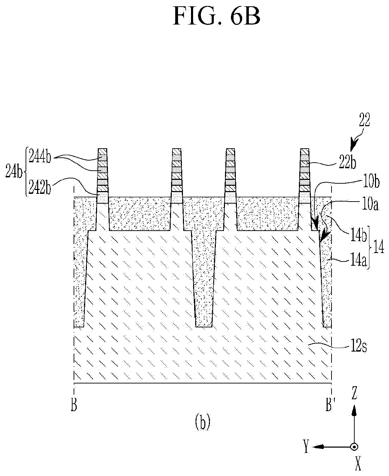

As shown in FIG. 6B, the stacking structure body 20t (refer to FIG. 6A) and the substrate 12s are partially removed to form a first separator 10a and a second separator 10b, and the first separator 10a and the second separator 10b are filled with an insulating material to form a substrate insulation layer 14 having a separating insulator 14a and an upper insulator 14b.

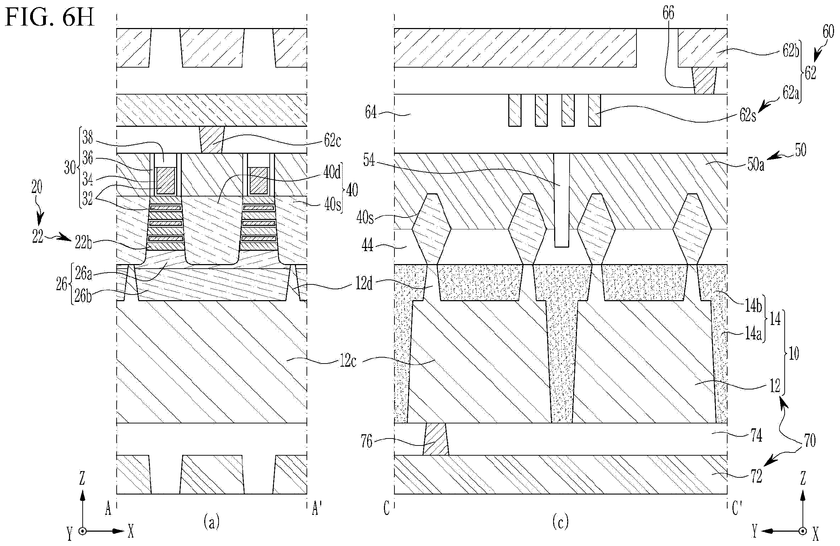

At this time, the first separator 10a may be formed by partially etching the stacking structure body 20t and the substrate 12s and may have a relatively large depth in the substrate 12s, and the second separator 10b may be formed by partially etching the stacking structure body 20t and the substrate 12s and may have a relatively small depth in the substrate 12s. According to this, a rear side of the second separator 10b may be disposed below a front side of the substrate 12s, and a rear side of the first separator 10a may be disposed below a front side of the substrate 12s and below the rear side of the second separator 10b. A portion of the first separator 10a disposed below the rear side of the second separator 10b at the substrate 12s may be a portion on which a main body 12c (refer to FIG. 6H) of a power wire 12 (refer to FIG. 6H) will be disposed. A portion of the first separator 10a disposed above the rear side of the second separator 10b at the substrate 12s may be a portion where a connector 12d (refer to FIG. 6H) of the power wire 12 will be disposed.

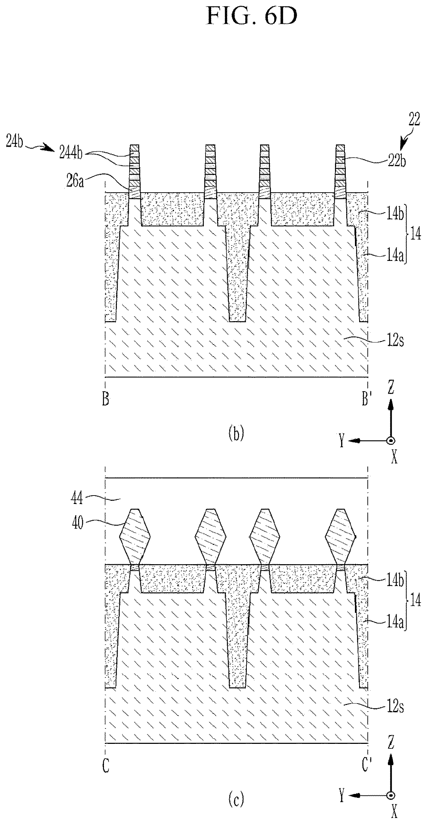

In an example embodiment, a front side of a substrate insulation layer 14 may be disposed between the rear side and the front side of the first sacrificial layer 242b, or on a plane that is substantially equivalent to the rear side of the first sacrificial layer 242b. According to this, the substrate insulation layer 14 generally covers the substrate 12s, resulting in an increase of stability in the process for removing the substrate 12s. The first sacrificial layer 242b may be exposed on the substrate insulation layer 14, and a process (e.g., a process described with reference to FIG. 6D) for selectively removing the first sacrificial layer 242b to replace the first sacrificial layer 242b with a first rear insulation layer 26a (refer to FIG. 6D) may be smoothly performed. But example embodiments are not limited thereto.

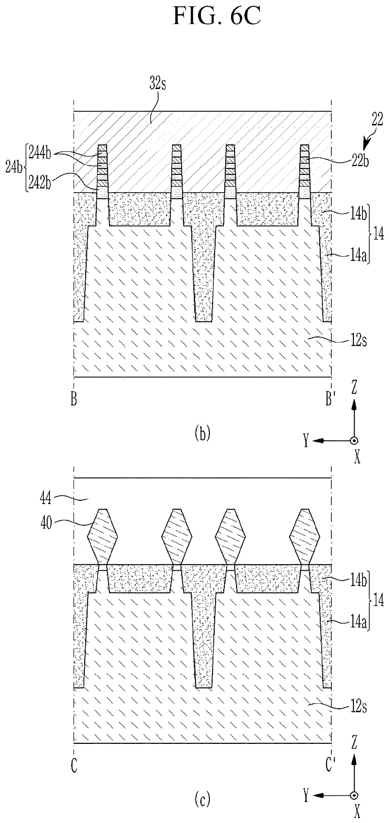

As shown in FIG. 6C, a dummy gate 32s and/or a gate spacer 36 (refer to FIG. 3C), source and drain regions 40, and an insulation layer 44 may be formed. Here, the description of the process referring to FIG. 3C may be applied to the process for forming a dummy gate 32s and/or a gate spacer 36, source and drain regions 40, and an insulation layer 44.

As shown in FIG. 6D, the dummy gate 32s of FIG. 3C may be removed, and the first sacrificial layer 242b provided in the active region 20 may be replaced with a first rear insulation layer 26a.

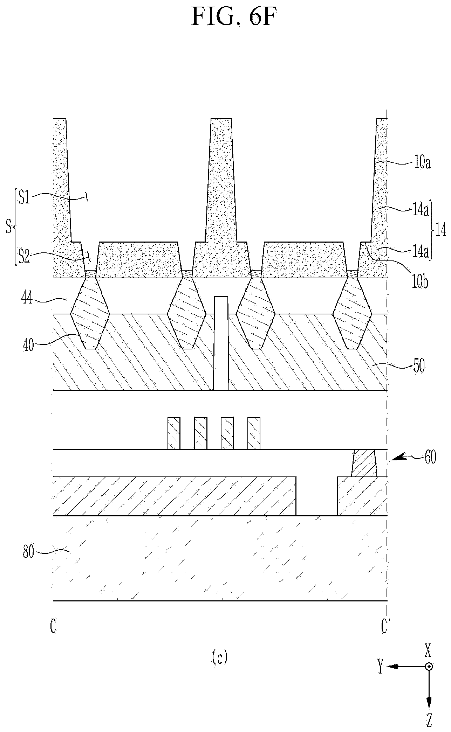

Any of various processes may be applied to the process for replacing the first sacrificial layer 242b provided in the active region 20 with the first rear insulation layer 26a. As described above, as the first sacrificial layer 242b has a different material or composition from the second sacrificial layer 244b, the first sacrificial layer 242b may be removed while remaining the second sacrificial layer 244b, by performing an etching process using an etching material for selectively removing the first sacrificial layer 242b. The first rear insulation layer 26a may be formed by forming an insulating material in the space where the first sacrificial layer 242b is removed. For example, the first rear insulation layer 26a may be formed by depositing the insulating material such as oxide, nitride, or oxynitride through a deposition process, and example embodiments are not limited thereto. The first rear insulation layer 26a may form a part of a rear insulation layer 26 (refer to FIG. 5), and may function as an etch stopper or an etch stopping layer in a process for removing the substrate 12s (refer to FIG. 6F).

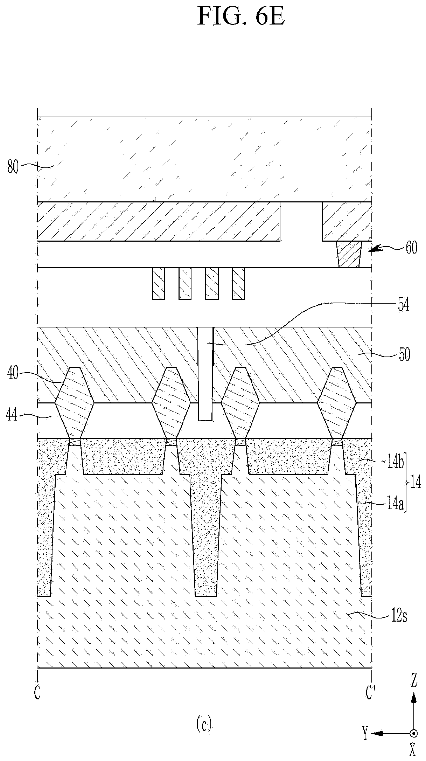

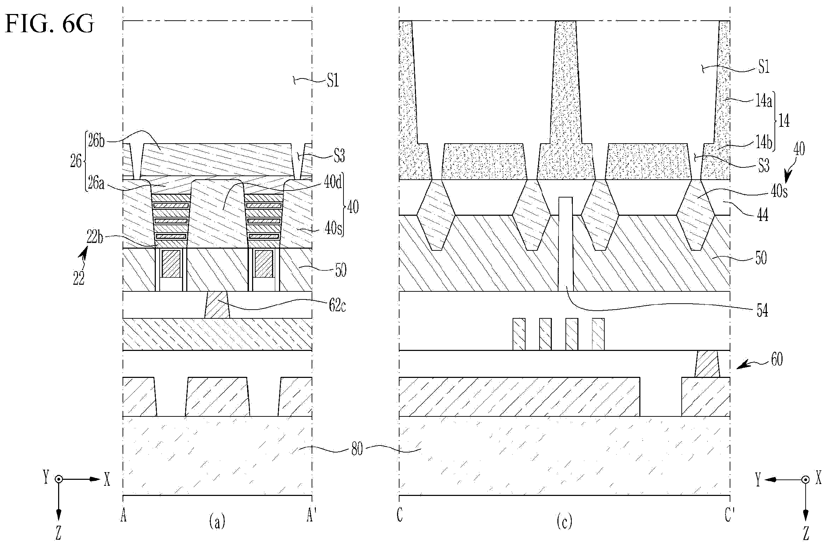

As shown in FIG. 6E, a gate structure 30 (refer to FIG. 6G) including a gate electrode 32 (refer to FIG. 6G) may be formed, source and drain electrodes 50 and an insulator 54 may be formed, a front wire portion 60 may be formed, and a carrier substrate 80 may be bonded on the front wire portion 60. The description with reference to FIG. 3D to FIG. 3F may be applied except that a penetration connector 52 is not formed and positions and shapes of an insulator 54 and the source and drain electrodes 50 are different.

As shown in FIG. 6F, the substrate 12s may be removed up to a rear side of the first separator 10a by performing a thinning process in a state that a rear portion of the substrate 12s is positioned at the top (e.g. rotated by 180 degrees), and a space portion S may be formed by removing the substrate 12s disposed in the separating insulator 14a and the upper insulator 14b.

The description with reference to FIG. 3G may be applied to the thinning process.

In the process for removing the substrate 12s to form the space portion S, an etching process using an etching material for selectively etching the substrate 12s may be used. In the example embodiment, the space portion S may include a first space portion S1 where a main body 12c (refer to FIG. 6H) will be disposed and a second space portion S2 where a connector 12d (refer to FIG. 6H) will be disposed. At this time, the first rear insulation layer 26a, which is disposed at a lower portion of the active region 20 in the second space portion S2, may work as an etch stopper or an etch stopping layer, and the etching may be stopped on the first rear insulation layer 26a.

As shown in FIG. 6G, a rear insulation layer 26 may be formed to fill the second space portion S2 (refer to FIG. 6F), and a penetrating portion S3 may be formed at the rear insulation layer 26 at a portion on which a connector 12d (refer to FIG. 6H) of the power wire 12 will be disposed.

For example, the rear insulation layer 26 may be formed by forming a second rear insulation layer 26b including an insulating material on the first rear insulation layer 26a. But example embodiments are not limited thereto. In some example embodiments, the first rear insulation layer 26a may be removed, and the rear insulation layer 26 may be formed of the second rear insulation layer 26b. Other numerous variations are possible.

Next, the penetrating portion S3 may be formed by partially removing a portion of the rear insulation layer 26 where the connector 12d of the power wire 12 is to be disposed by using a patterning process. For example, the penetrating portion S3 may be formed to expose a source region 40s and may not be formed at a drain region 40d, but example embodiments are not limited thereto.

As shown in FIG. 6H, a power wire 12 having a main body 12c and a connector 12d may be formed by filling a conductive material in the first space portion S1 and the penetrating portion S3. A rear wire portion 70 including the power wire 12 may be formed by additionally forming a rear wire layer 72, an interlayer insulating layer 74, and a contact via 76. Except that the connector 12d is additionally provided, the descriptions with reference to FIG. 3J may be applied. Depending on example embodiments, a carrier substrate 80 may be provided or may not be provided on the front wire portion 60.

According to the example embodiment, the power wire 12 is connected to a rear side of at least one of the source and drain regions 40 by using the connector 12d which is a part of the power wire 12, without a penetration connector 52. Thus, a power transmitting path may be effectively reduced. A process for manufacturing the semiconductor device 100a may be simplified by forming the power wire 12 having the connector 12d using a self-aligning process.

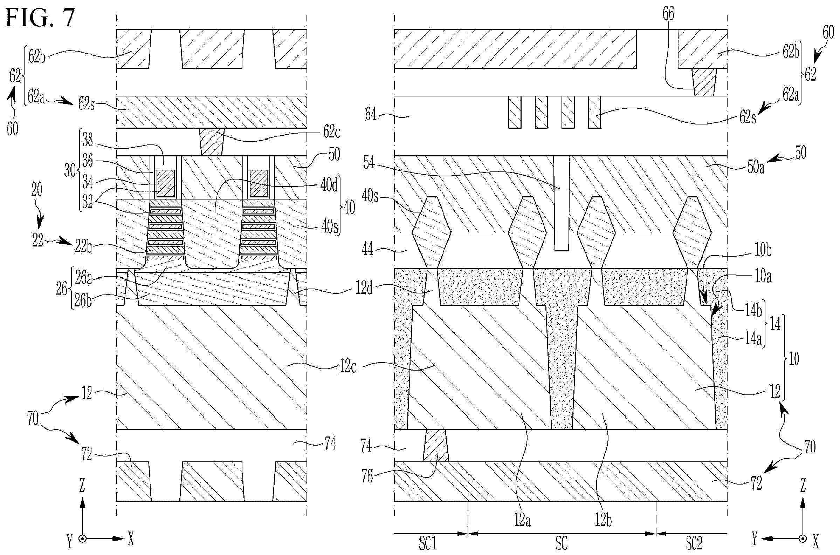

FIG. 5 and FIG. 6A to FIG. 6H show a structure in which the lowermost layer of the second channel layer 22b is positioned on the rear insulation layer 26, but example embodiments are not limited thereto. In another example embodiment as shown in FIG. 7, a gate insulating layer 34 and a gate electrode 32 may be further disposed between the rear insulation layer 26 and the second channel layer 22b. When a second sacrificial layer 244b is further provided between the first sacrificial layer 242b and the second channel layer 22b while the stacking structure body 20t is formed in the process shown in FIG. 6A, the semiconductor device with the structure shown in FIG. 7 may be manufactured.

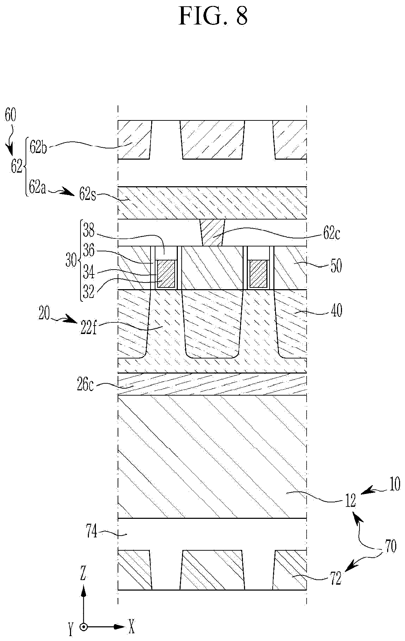

FIG. 8 shows a cross-sectional view of a semiconductor device according to another example embodiment. FIG. 8 shows a portion that corresponds to a left portion of FIG. 2.

Referring to FIG. 8, in the example embodiment, an active region 20 may include or be formed of a fin portion 22f, which is a part of a substrate 12s (refer to FIG. 3A). The active region may not include a channel layer 22 (refer to FIG. 2). The fin portion 22f may represent a portion protruding in a third direction (e.g., a Z-axis direction in the drawing) from a front side of a substrate insulation layer 14 on the substrate 12s. For example, at least a part of the fin portion 22f may extend in a first direction, and a plurality of fin portions 22f may be provided at one active region 20 in the second direction (a Y-axis direction in the drawing). However, example embodiments are not limited thereto, and numerous variations are possible.

Portions that are different from the description with reference to FIG. 3A to FIG. 3I in a method for manufacturing a semiconductor device as shown in FIG. 8 are as follows. A process for forming a channel layer 22 and a sacrificial layer 24b is not provided, and a first separator 10a (refer to FIG. 2) and a second separator 10b (refer to FIG. 2) may be formed at the substrate 12s, and a substrate insulation layer 14 may be formed. In a process for removing the substrate 12s described with reference to FIG. 3G, a part of the substrate 12s positioned below a front side of the substrate insulation layer 14 or a rear side of source and drain regions 40 may be removed. A process for remaining the fin portion 22f of the substrate 12s constituting the active region 20 and removing other portions of the substrate 12s may be implemented by adjusting process conditions of the etching process. A process for forming a rear insulation layer 26c may be further performed before the process for forming the power wire 12 described with reference to FIG. 3I is performed

As described above, the fin portion 22f may be formed of a part of the substrate 12s, which is formed of a semiconductor substrate including a semiconductor material. In some example embodiments, the fin portion 22f may include an epitaxial layer grown on the substrate 12s. In this case, instead of the process for forming the channel layer 22 and the sacrificial layer 24b, a process for forming an epitaxial layer or a process for forming a rear insulation layer and an epitaxial layer may be performed.

FIG. 8 and descriptions thereof are based on a structure of FIG. 2 except for the active region 20 for a purpose of illustration, and example embodiments are not limited thereto. Therefore, in some example embodiments or modifications with reference to FIG. 5 or FIG. 7, the active region 20 may include or be formed of the fin portion 22f. Other numerous variations are possible.

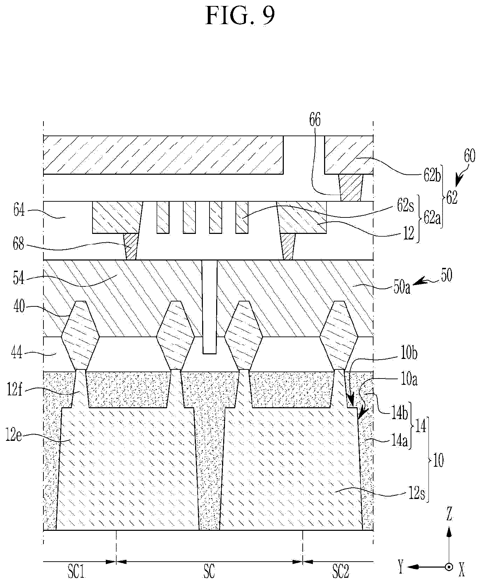

FIG. 9 shows a cross-sectional view of a semiconductor device according to another example embodiment. FIG. 9 shows a portion that corresponds to the drawing shown on the right portion of FIG. 2.

Referring to FIG. 9, in an example embodiment, a first wire layer 62a of a front wire portion 60 may include a signal wire 62s and a power wire 12. The power wire 12 may be connected to source and drain electrodes 50 through a contact via 68. In the present example embodiment, the power wire 12 may be included in the front wire portion 60. That is, in the example embodiment with reference to FIG. 9, the power wire 12 is disposed on a front side rather than a rear side of the semiconductor device, and the support member 10 includes a substrate 12s and a substrate insulation layer 14, which is different from the above-described example embodiment. Although not shown in FIG. 9, at least a part of a second wire layer 62b may be connected to the power wire 12.

For example, the signal wire 62s may be disposed corresponding to a center region of a standard cell SC and a separating insulator 14a, and the power wire 12 may be disposed corresponding to a boundary region or an upper insulator 14b. However, example embodiments are not limited to this, and positions and shapes of the signal wire 62s and the power wire 12 may be variously modified.

In a method for manufacturing a semiconductor device as illustrated in FIG. 9, portions that are different from the descriptions referring to FIG. 3A to FIG. 3I will be described. An etch stopper 24a in FIG. 3A is not provided, and the front wire portion 60 includes the power wire 12 and thus the power wire 12 is formed in the process for forming the front wire portion 60.

The process for removing the substrate 12s described with reference to FIG. 3G and the process forforming the power wire 12 described reference to FIG. 3I are not performed. In an example embodiment, the first channel layer 22a may not be provided.

For example, referring to FIG. 9, a second separator 10b may be disposed in the substrate 12s and a rear insulation layer 26 (refer to FIG. 2) may not be provided. According to this, the substrate 12s may include a main body 12e and an extension 12f extending from the main body 12e to the channel layer 22 (refer to FIG. 2) and/or the source and drain regions 40. At this time, a first channel layer 22a of FIG. 2 may not be provided, and the extension 12f of the substrate 12s may form an active region 20 together with a second channel layer 22b (refer to FIG. 2). A manufacturing process may be simplified and the active region 20 may be stably separated by the extension 12f.

However, example embodiments are not limited to this, and the first channel layer 22a may be provided instead of at least a part of the extension 12f, and other numerous variations are possible. The structure shown in FIG. 9 is just an example, and at least a part of the structures according to the example embodiments with reference to FIG. 2, FIG. 5, FIG. 7, or FIG. 8 may be applied in the structure in which the power wire 12 is disposed at the front side of the semiconductor device.

While this disclosure has been described in connection with what is presently considered to be some practical example embodiments, it is to be understood that the disclosure is not limited to the disclosed example embodiments, but, on the contrary, is intended to cover various modifications and equivalent arrangements included within the scope of the appended claims.

## Claims

1. A semiconductor device comprising:
a support member including a substrate insulation layer and a power wire, the substrate insulating layer including a plurality of separating insulators, the power wire being at a space between the plurality of separating insulators;
an active region on the power wire;
source and drain regions adjacent to the active region; and
a gate electrode on the active region.

2. The semiconductor device of claim 1, wherein a lateral side between a corresponding one of the separating insulators and the power wire includes a slope side or an inclined surface so that a width of the corresponding one of the separating insulators narrows, and a width of the power wire widens, when approaching a rear side of the support member from a front side of the support member.

3. The semiconductor device of claim 1 or 2, wherein each of the separating insulators corresponds to a center region of a corresponding standard cell; and/or
the power wire includes a first power wire shared by the standard cell and a first adjacent cell adjacent to one side of the standard cell, and a second power wire shared by the standard cell and a second adjacent cell adjacent to another side of the standard cell.

4. The semiconductor device of any preceding claim, wherein the support member includes the substrate insulation layer and the power wire and does not include a semiconductor substrate.

5. The semiconductor device of claim 4, wherein a thickness of the power wire is substantially equivalent to a depth of a corresponding one of the separating insulators, and/or an entire portion of a lateral side of the power wire contacts an entire portion of a lateral side of the corresponding one of the separating insulators.

6. The semiconductor device of any preceding claim, further comprising:
an insulating portion including an insulating material and being on the power wire, and
a penetration connector penetrating the insulating portion to connect at least one of source and drain electrodes connected to the source and drain regions and the power wire.

7. The semiconductor device of claim 6, wherein a lateral side of the penetration connector includes a slope side or an inclined surface so that a width of the penetration connector narrows when approaching a rear side from a front side.

8. The semiconductor device of claim 6 or 7, further comprising:
a rear insulation layer between the power wire and the active region and between the power wire and the source and drain regions.

9. The semiconductor device of any one of claims to 8 6, wherein at least one of the source and drain electrodes includes a main body portion and an extending portion, the main body on the substrate insulation layer with an insulation layer interposed therebetween, the extending portion penetrating the insulation layer and connecting the main body portion and the penetration connector.

10. The semiconductor device of claim 9, further comprising:
an insulator separating the source and drain electrodes,
wherein a lower side of the insulator is below a lower side of the extending portion.

11. The semiconductor device of any preceding claim, wherein the power wire further includes a connector connected to a rear side of at least one of the source and drain regions.

12. The semiconductor device of any preceding claim, wherein the semiconductor further comprises a rear wire portion disposed on a rear side of the support member, and the rear wire portion includes the power wire; or
a thickness of the power wire is less than a height to a front side of the active region from the front side of the power wire.

13. A method of manufacturing a semiconductor device comprising:
providing a support structure including a substrate;
forming a substrate insulation layer including a separating insulator and an upper insulator, by forming a plurality of first separators and a second separator and filling the first separators and the second separator with an insulating material, a rear side of the second separator being higher than the first separators in the support structure;
forming source and drain regions and a gate electrode on the support structure;
forming a space portion by removing at least a part of the substrate disposed between the first separators; and
forming a power wire by filling a conductive material in the space portion.

14. The method of claim 13, further comprising:
removing a rear side of the substrate up to a rear side of the plurality of first separators between the forming of the source and drain regions and the gate electrode and the forming of the space portion.

15. The method of claim 13 or 14, wherein the forming of the substrate insulation layer includes forming the plurality of first separators by an etching process performed at a front side of the support structure, and
in the forming of the power wire, a lateral side of the space portion includes a slope side or an inclined surface so that a width of the space portion widens as approaching a rear side of the support structure from the front side of the support structure, and the conductive material is filled at the rear side of the support structure.
